# EUROPEAN PATENT SPECIFICATION

(11) **EP 3 125 321 B1**
(45) Date of publication and mention of the grant of the patent: **11.03.2020**
(21) Application number: 15770274.7
(22) Date of filing: 27.03.2015
(51) Int. Cl.: H01L 51/30, H01L 21/368, H01L 29/786

(54) **ORGANIC-SEMICONDUCTOR-FILM-FORMING COMPOSITION**
ZUSAMMENSETZUNG ZUR BILDUNG EINER ORGANISCHEN HALBLEITERSCHICHT
COMPOSITION FILMOGÈNE ORGANIQUE SEMI-CONDUCTRICE

(30) Priority: 28.03.2014 JP 2014070247
(43) Date of publication of application: 01.02.2017
(73) Proprietor: Fujifilm Corporation, Minato-ku Tokyo 106-8620 (JP)
(72) Inventor: HAYATA Yuuichi, Ashigara-kami-gun Kanagawa 258-8577 (JP); KARIYA Toshihiro, Ashigara-kami-gun Kanagawa 258-8577 (JP); HIRAI Yuki, Ashigara-kami-gun Kanagawa 258-8577 (JP)
(74) Representative: Hoffmann Eitle
(86) International application number: PCT/JP2015/059638
(87) International publication number: WO 2015/147266

(56) References cited:
- WO-A1-2012/115236
- WO-A1-2013/041822
- WO-A1-2014/140568
- JP-A- 2011 032 268
- JP-A- 2013 069 752
- JP-A- 2013 225 639

## Description

### BACKGROUND OF THE INVENTION

### 1. Field of the Invention

The present invention relates to an organic semiconductor film forming composition.

### 2. Description of the Related Art

From the viewpoints of weight reduction, low cost, and softening, an organic transistor (organic TFT) having an organic semiconductor film (organic semiconductor layer) has been used for a field effect transistor (FET), an RF tag (RFID), or the like in a liquid crystal display or an organic EL display.

As a method of preparing an organic semiconductor film, various methods have been suggested. For example, JP2012-517673A discloses a method of producing an organic layer using a composition that includes a predetermined organic solvent. Document WO2013/041822 A1 discloses a composition of di-n-hexyl dibenzo[d,d']thieno[3,2-b;4,5-b']dithiophene and di-n-ethyl dibenzo[d,d']thieno[3,2-b;4,5-b']dithiophene in ortho-xylene.

Document JP2013069752 A discloses a composition of di-n-hexyl dithienobenzodithiophene and din-butyl dithienobenzodithiophene in toluene.

Document JP2013225639 A discloses chloroform ink solutions containing a mixture of dithienobenzodithiophene-based compounds.

### SUMMARY OF THE INVENTION

In recent years, in terms of improving performance of an electronic device such as an organic transistor, it is necessary to further improve the mobility of an organic semiconductor film. Moreover, in order to improve the quality of an electronic device, it is necessary that a variation in mobility of an organic semiconductor film between samples (between lots) be low. That is, it is necessary that an organic semiconductor film have excellent mobility and a small variation in mobility.

When an organic semiconductor film is prepared using a solvent described in JP2012-517673A and the mobility thereof and the variation in mobility are evaluated by the present inventors, the recent requirements are not necessarily satisfied and thus further improvement is required.

The present invention has been made in consideration of the above-described circumstances and an object thereof is to provide an organic semiconductor film forming composition which is capable of producing an organic semiconductor film showing excellent mobility and having a small variation in mobility between samples.

As a result of intensive research on the above-described problems conducted by the present inventors, they found that desired effects can be obtained by selecting a specific organic semiconductor material, thereby completing the present invention. That is, the present inventors found that the above-described problems can be solved by the following configurations.
(1) An organic semiconductor film forming composition comprising at least: a first organic semiconductor compound which includes a mother nucleus that has two or more thiophene rings and is formed of a fused ring structure having at least four or more rings including the thiophene rings, and a substituent X bonded to the mother nucleus in a molecule; a second organic semiconductor compound which includes the same mother nucleus as the mother nucleus of the first organic semiconductor compound and satisfies any one requirement selected from the group consisting of the following requirements 1 to 3; and an organic solvent, wherein the mother nucleus includes at least three or more thiophene rings, wherein the substituent X and the substituent Y are substituents each including an alkyl group having 1 to 16 carbon atoms, and a ratio of the mass of the first organic semiconductor compound to the mass of the second organic semiconductor compound is in a range of 0.3 to 3.0, and the ratio indicates the mass of the first organic semiconductor compound to the mass of the second organic semiconductor compound in the film forming composition.
(2) The organic semiconductor film forming composition according to (1), in which the mother nucleus includes three or four thiophene rings.
(3) The organic semiconductor film forming composition according to any one of (1) or (2), in which the mother nucleus includes three thiophene rings.
(4) The organic semiconductor film forming composition according to any one of (1) to (3), in which the number of rings in the mother nucleus is five.
(5) The organic semiconductor film forming composition according to any one of (1) to (4) in which the alkyl group is a linear alkyl group.
(6) The organic semiconductor film forming composition according to any one of (1) to (5), in which the second organic semiconductor compound satisfies the requirement 1 or the requirement 2, the first organic semiconductor compound includes two substituents X and the second organic semiconductor compound includes two substituents Y in a case where the requirement 1 is satisfied, and the first organic semiconductor compound includes two substituents X and the second organic semiconductor compound includes two substituents X in a case where the requirement 2 is satisfied.
(7) The organic semiconductor film forming composition according to any one of (1) to (5), in which the second organic semiconductor compound satisfies the requirement 1, and the binding position of the substituent X with respect to the mother nucleus in the first organic semiconductor compound is the same as a binding position of the substituent Y with respect to the mother nucleus in the second organic semiconductor compound.
(8) The organic semiconductor film forming composition according to any one of (1) to (5) and (7), in which the second organic semiconductor compound satisfies the requirement 1, and a difference in the number of carbon atoms between the substituent X and the substituent Y is 4 or less.
(9) The organic semiconductor film forming composition according to any one of (1) to (8), in which the second organic semiconductor compound satisfies the requirement 1, and the substituent X and the substituent Y are linear alkyl groups each having 1 to 16 carbon atoms.
(10) The organic semiconductor film forming composition according to any one of (1) to (9), in which the total amount of the first organic semiconductor compound and the second organic semiconductor compound is in a range of 0.4% to 10.0% by mass with respect to the total mass of the composition.
(11) The organic semiconductor film forming composition according to any one of (1) to (10), in which the total amount of the first organic semiconductor compound and the second organic semiconductor compound is in a range of 0.6% to 8.0% by mass with respect to the total mass of the composition.
(12) The organic semiconductor film forming composition according to any one of (1) to (11), in which a ratio of the mass of the first organic semiconductor compound to the mass of the second organic semiconductor compound is in a range of 0.5 to 2.0, and the ratio indicates the mass of the first organic semiconductor compound to the mass of a second organic semiconductor compound in the film forming composition.

### BRIEF DESCRIPTION OF THE DRAWINGS

Fig. 1 is a view schematically illustrating a section of an organic thin-film transistor according to an embodiment of the present invention.
Fig. 2 is a view schematically illustrating a section of an organic thin-film transistor according to another embodiment of the present invention.
Fig. 3 is a plan view of a metal mask used in an example.

### DESCRIPTION OF THE PREFERRED EMBODIMENTS

Hereinafter, preferred embodiments of an organic semiconductor film forming composition (hereinafter, also simply referred to as a "composition") of the present invention will be described. In the present specification, the numerical ranges shown using "to" indicate ranges including the numerical values described before and after "to" as the lower limits and the upper limits.

The composition of the present invention has a characteristic of using a combination of two kinds of predetermined organic semiconductor compounds. First, the present inventors found that the solubility in an organic solvent is further improved when predetermined two kinds of organic semiconductor compounds are used, compared to a case where one organic semiconductor compound is used. When the concentration of an organic semiconductor compound in an organic solvent is increased, the coating amount at the time of producing an organic semiconductor film with a predetermined thickness can be reduced. Moreover, the growth of crystals in an organic semiconductor film is affected by the amount of an organic solvent included in a coating film. Consequently, the amount of the organic solvent in the coating film between samples (between lots) varies, the size of crystals to be formed changes, and a variation in mobility of an organic semiconductor film to be formed easily occurs. In the composition of the present invention, it is possible to adjust the concentration of an organic semiconductor compound to be higher as described above. As a result, the amount of the organic solvent in the coating film can be reduced and, accordingly, a variation in amount of the organic solvent between samples is reduced. Therefore, a variation in crystallinity caused by the organic solvent being dried is suppressed and a variation in mobility between samples is reduced.

Further, when the concentration of an organic semiconductor compound in the composition is higher, since a so-called supersaturated concentration state is easily maintained after the organic solvent is dried and crystal nuclei are formed, crystallization easily proceeds instantaneously from a small amount of crystal nuclei. As a result, uniform crystals with less crystal boundaries can be easily obtained. Therefore, the mobility of an organic semiconductor film to be formed is easily improved more.

Hereinafter, first, components included in the composition will be described in detail.

### <First organic semiconductor compound and second organic semiconductor compound>

The first organic semiconductor compound and the second organic semiconductor compound have the same mother nucleus in a molecule. This mother nucleus includes three or more thiophene rings and has a fused ring structure (fused polycyclic structure) having 4 or more rings including the thiophene rings. In other words, the mother nucleus is formed (configured) of this fused ring structure. Moreover, the present composition may include other organic semiconductor compounds other than the first organic semiconductor compound and the second organic semiconductor compound.

From the viewpoints that the mother nucleus includes three or more thiophene rings (thiophene ring structure), the mobility of an organic semiconductor film to be formed is more excellent, and/or a variation in mobility between samples is smaller (hereinafter, also simply referred to as "the viewpoint of obtaining more excellent effects of the present invention"), the mother nucleus (fused ring structure) included in the first organic semiconductor compound and the second semiconductor compound has 3 or more thiophene rings, more preferably 3 to 5 thiophene rings, still more preferably 3 or 4 thiophene rings. When the number of thiophene rings is in the above-described preferable ranges, the area of mother nuclei overlapping each other is increased in a crystal state while the solubility of the first organic semiconductor compound and the second organic semiconductor compound in the composition is maintained to be high. As a result, high mobility is obtained and a variation in mobility between samples is further suppressed.

The fused ring structure has three or more thiophene rings as described above and the number of rings (total number of rings) is 4 or greater. From the viewpoint of obtaining more excellent effects of the present invention, the number of rings is preferably in a range of 4 to 6, more preferably 5 or 6, and still more preferably 5.

Moreover, the fused ring structure (fused polycyclic structure) is a structure obtained by a plurality of aromatic rings being fused. Examples of the aromatic ring include an aromatic hydrocarbon ring and an aromatic heterocycle. Examples of the aromatic hydrocarbon ring include a benzene ring. Further, it is considered that the fused ring structure has two benzene rings in a case where the fused ring structure has a naphthalene ring.

Examples of the aromatic heterocycle include a thiophene ring, a furan ring, a pyrrole ring, a selenophene ring, an imidazole ring, a pyrazole ring, an oxazole ring, an isoxazole ring, a thiazole ring, an isothiazole ring, a triazole ring, a thiadiazole ring, a diazole ring, a pyridine ring, a pyrazine ring, a pyridine ring, a pyrimidine ring, a pyridazine ring, a pyrazine ring, and a triazine ring.

As an embodiment of the above-described fused ring structure (mother nucleus), a fused ring structure which has three thiophene rings and in which the number of rings is five may be exemplified from the viewpoint of obtaining more excellent effects of the present invention. Among the examples thereof, a fused ring structure which has two benzene rings and three thiophene rings and in which the number of rings is five is most preferable.

Further, as another preferred embodiment of the fused ring structure (mother nucleus), a fused ring structure in which thiophene rings and benzene rings are alternately fused may be exemplified from the viewpoint of obtaining more excellent effects of the present invention.

Moreover, the second organic semiconductor compound is a compound that has the above-described mother nucleus and satisfies any one of the following Requirements 1 to 3.
Requirement 1: The second organic semiconductor compound includes a substituent Y which is bonded to the mother nucleus in the second organic semiconductor compound and different from the substituent X in the first organic semiconductor compound.
Requirement 2: The second organic semiconductor compound includes a substituent X bonded to the mother nucleus, and a binding position of the substituent X with respect to the mother nucleus in the first organic semiconductor compound is different from a binding position of the substituent X with respect to the mother nucleus in the second organic semiconductor compound.
Requirement 3: The second organic semiconductor compound does not include a substituent.

In other words, the second organic semiconductor compound is an "organic semiconductor compound which has the same mother nucleus as the first organic semiconductor compound and includes a substituent Y which is different from the substituent X in the first organic semiconductor compound (the type thereof is different from the substituent X) and bonded to the mother nucleus" (compound 1); an "organic semiconductor compound which has the same mother nucleus as the first organic semiconductor compound, includes a substituent X (the same group as the substituent X in the first organic semiconductor compound) bonded to the mother nucleus, and is formed by the substituent X being bonded to the mother nucleus at a binding position which is different from the binding position of the substituent X with respect to the mother nucleus in the first organic semiconductor compound" (compound 2); or an "organic semiconductor compound which has the same mother nucleus as the first organic semiconductor compound and does not include a substituent" (compound 3).

More specifically, in a case where the composition includes the compound 1, this means that the composition includes two kinds of organic semiconductor compounds having the same mother nucleus and different substituents. Further, in a case where the composition includes the compound 2, this means that the composition includes two kinds of organic semiconductor compounds having the same mother nucleus, the same substituent, and different binding positions of the substituent with respect to the mother nucleus. Furthermore, in a case where the composition includes the compound 3, this means that the composition includes an organic semiconductor compound having a substituent and an organic semiconductor compound which does not have a substituent. In addition, the compound 3 does not have a substituent, but examples of the substituent include a substituent W described below.

Among the requirements, from the viewpoint of obtaining more excellent effects of the present invention, it is preferable that Requirement 1 is satisfied.

The substituents (the substituent X and the substituent Y) included in the first organic semiconductor compound and the second organic semiconductor compound are substituents each including an alkyl group having 1 to 16 carbon atoms. From the viewpoints that the solubility of a compound in an organic solvent is more excellent and the effects of the present invention are more excellent, the number of carbon atoms thereof is preferably in a range of 1 to 12 and more preferably in a range of 2 to 8.

The alkyl group may be linear, branched, or cyclic, but is preferably linear.

Further, in a case where the second organic semiconductor compound satisfies the above-described Requirement 1 (in a case where the second organic semiconductor compound is the compound 1) and the substituent X and the substituent Y are substituents each including an alkyl group having 1 to 16 carbon atoms, from the viewpoint of obtaining more excellent effects of the present invention, a difference in number of carbon atoms between the substituent X and the substituent Y is preferably 4 or less, more preferably 2 or less, and still more preferably 1 or less.

In a case where the second organic semiconductor compound satisfies the above-described Requirement 1, the number of substituents X (alternatively, the substituents Y included in the second organic semiconductor compound) included in the first organic semiconductor compound is not particularly limited, but the number thereof is preferably 2 or greater, more preferably in a range of 2 to 4, and still more preferably 2, from the viewpoint of obtaining more excellent effects of the present invention.

In a case where the second organic semiconductor compound satisfies the above-described Requirement 2, the number of substituents X (alternatively, the substituents X included in the second organic semiconductor compound) included in the first organic semiconductor compound is not particularly limited, but the number thereof is preferably 2 or greater, more preferably in a range of 2 to 4, and still more preferably 2, from the viewpoint of obtaining more excellent effects of the present invention.

In the case where the second organic semiconductor compound satisfies the above-described Requirement 1, the binding positions (substitution positions) of the substituent X and the substituent Y with respect to the mother nuclei are not particularly limited, but it is preferable that the binding position of the substituent X with respect to the mother nucleus in the first organic semiconductor compound is the same as the binding position of the substituent Y with respect to the mother nucleus in the second organic semiconductor compound, from the viewpoint of obtaining more excellent effects of the present invention.

In the case where the second organic semiconductor compound satisfies the above-described Requirement 1, the first organic semiconductor compound and the second semiconductor compound respectively have a structure in which a substituent is bonded to the mother nucleus as described above. The first organic semiconductor compound and the second semiconductor compound can be represented by the following Formulae (X) and (Y).

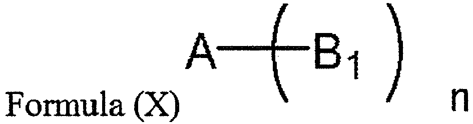

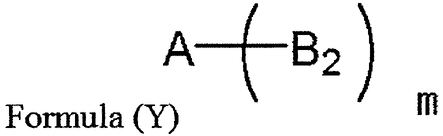

In Formulae (X) and (Y), A represents a mother nucleus (fused ring structure), B¹ represents a substituent X, and B² represents a substituent Y. n and m represent an integer of 1 or greater.

As described above, B¹ and B² represent substituents different from each other.

From the viewpoint of obtaining more excellent effects of the present invention, n and m represent preferably 2 or greater, more preferably 2 to 4, and still more preferably 2.

Moreover, in the present specification, the mother nucleus indicates a portion forming a main skeleton in the first organic semiconductor compound (or the second organic semiconductor compound). Further, the main skeleton indicates that the molecular weight of the mother nucleus is 50% by mass or greater with respect to the total molecular weight in the first organic semiconductor compound (or the second organic semiconductor compound).

According to the preferred embodiment, from the viewpoint of obtaining more excellent effects of the present invention, the first organic semiconductor compound and the second organic semiconductor compound includes at least one selected from the group consisting of compounds represented by Formulae (5) to (7) and (13) to (15). Note that Formulae (1) to (4) and (8) to (12) are not forming part of the present invention.

Further, a portion (structure) to which a group represented by R¹ to R¹⁰ in Formulae (1) to (15) corresponds to the mother nucleus.

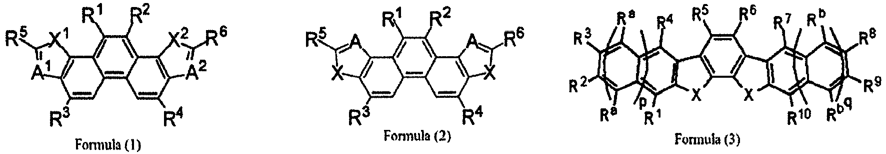

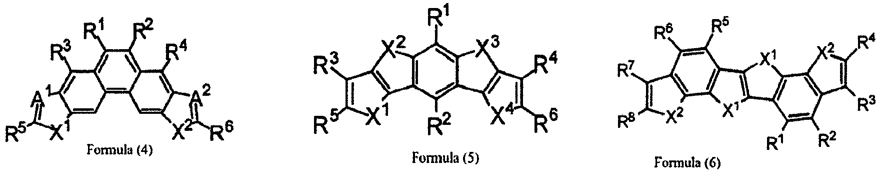

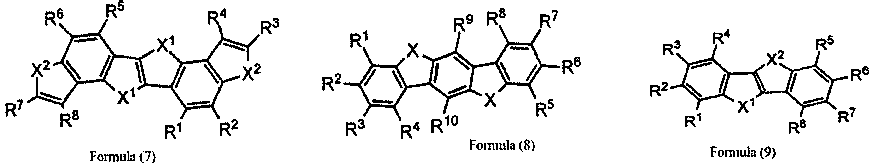

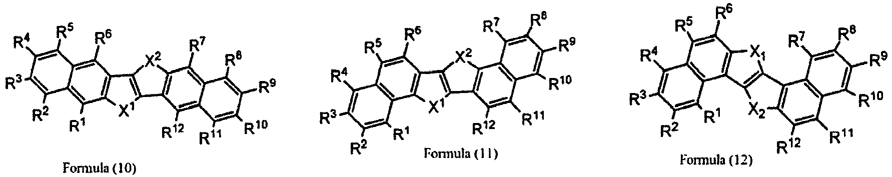

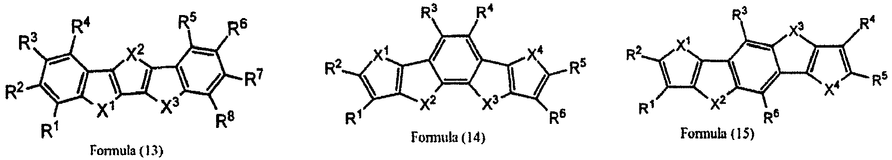

Hereinafter, first, substituents which may be used for the compounds represented by Fonnulae (1) to (15) and are represented by Formula (W) will be described in detail. Thereafter, groups included in each of the compounds will be described in detail.

First, substituents represented by Formula (W) will be described.

Formula (W) -L-R

In Formula (W), L represents a divalent linking group represented by any of the following Formulae (L-1) to (L-25) or a divalent linking group formed by two or more divalent linking groups, represented by any of the following Formulae (L-1) to (L-25), being bonded to each other.

| | | | | | |
|---|---|---|---|---|---|
| 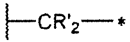 | (L-1) | 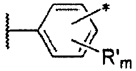 | (L-13) | 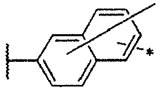 | R'ₘ (L-22) |
| 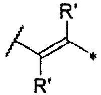 | (L-2) | 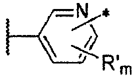 | (L-14) | | |
| | | | | 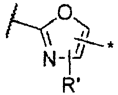 | (L-23) |
| 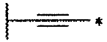 | (L-3) | 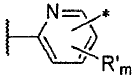 | (L-15) | | |
| 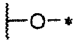 | (L-4) | | | 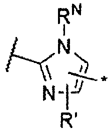 | (L-24) |
| 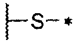 | (L-5) | 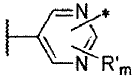 | (L-16) | | |
| 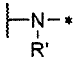 | (L-6) | | | | |
| 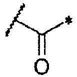 | (L-7) | 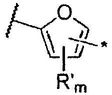 | (L-17) | 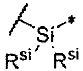 | (L-25) |
| 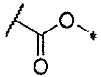 | (L-8) | 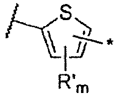 | (L-18) | | |
| 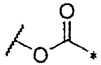 | (L-9) | | | | |
| | | 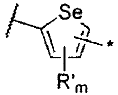 | (L-19) | | |
| 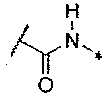 | (L-10) | | | | |
| | | 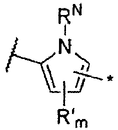 | (L-20) | | |
| 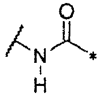 | (L-11) | | | | |
| 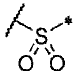 | (L-12) | 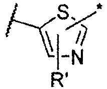 | (L-21) | | |

In Formula (L-1) to (L-25), each symbol "*" represents a binding position with respect to R and each wavy line part indicates the other binding position. More specifically, in a case where a compound represented by Formula (1) described below includes a substituent represented by Formula (W), the wavy line part is bonded to a ring forming a skeleton represented by Formula (1). Further, as described below, in a case where the substituent represented by Formula (W) is included in other compounds, the wavy line part is bonded to a ring forming a skeleton of each compound.

Moreover, in a case where L represents a divalent linking group formed by two or more divalent linking groups, represented by any of Formulae (L-1) to (L-25), being bonded to each other, a symbol "*" of a linking group is bonded to a wavy line part of another linking group.

m in Formula (L-13) represents 4, m's in Formulae (L-14) and (L-15) represent 3, m's in Formulae (L-16) to (L-20) represent 2, and m in Formula (L-22) represents 6.

In Formulae (L-1), (L-2), (L-6), and (L-13) to (L-24), (R')'s each independently represents a hydrogen atom or a substituent. R^{N}'s represent a hydrogen atom or a substituent. R^{si}'s each independently represent a hydrogen atom, an alkyl group, an alkenyl group, or an alkynyl group.

(R')'s in Formulae (L-1) and (L-2) may be respectively bonded to R adjacent to L and form a fused ring.

Here, it is more preferable that the divalent linking groups represented by Formulae (L-17) to (L-21), (L-23), and (L-24) are divalent linking groups represented by the following Formulae (L-17A) to (L-21 A), (L-23A), and (L-24A).

| | | | |
|---|---|---|---|
| 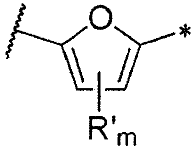 | (L-17A) | 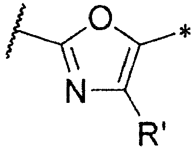 | (L-23A) |
| 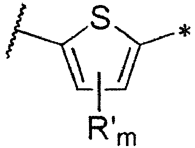 | (L -18A) | 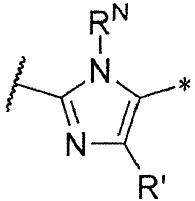 | (L-24A) |
| 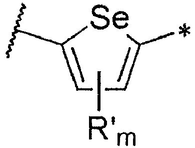 | (L-19A) | | |
| 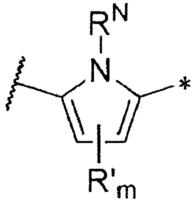 | (L-20A) | | |
| 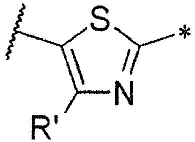 | (L-21A) | | |

Here, in a case where a substituted or unsubstituted alkyl group, a cyano group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent can be interpreted as -R alone in Formula (W) or as -L-R in Formula (W).

In the present invention, in a case where a substituted or unsubstituted alkyl group having N carbon atoms in the main chain is present at the terminal of a substituent, this substituent is determined to be interpreted as -L-R in Formula (W), including as many linking groups as possible from the terminal of the substituent. Specifically, this substituent is interpreted as a substituent in which "one (L-1) corresponding to L in Formula (W)" is bonded to "a substituted or unsubstituted alkyl group having N-1 carbon atoms in the main chain corresponding to R in Formula (W)." For example, in a case where an n-octyl group which is an alkyl group having 8 carbon atoms is present at the terminal of a substituent, this substituent is interpreted as a substituent in which one (L-1) having two (R')'s representing a hydrogen atom is bonded to an n-heptyl group having 7 carbon atoms.

Meanwhile, in the present invention, in a case where an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent is interpreted as R alone in Formula (W), including linking groups as many as possible from the terminal of the substituent. For example, in a case where a -(OCH₂CH₂)-(OCH₂CH₂)-(OCH₂CH₂)-OCH₃ group is present at the terminal of a substituent, this substituent is interpreted as a substituent of an oligooxyethylene group alone in which the repeating number v of oxyethylene units is 3.

In a case where a linking group to which a divalent linking group in which L is represented by any of Formulae (L-1) to (L-25) is formed, the number of bonds of the divalent linking group represented by any of Formulae (L-1) to (L-25) is preferably in a range of 2 to 4 and more preferably 2 or 3.

Examples of the substituent R' in Formulae (L-1), (L-2), (L-6), and (L-13) to (L-24) include those exemplified as the substituents which may be employed by R¹ to R⁸ of Formula (1) described below. Among these, it is preferable that the substituent R' in Formula (L-6) represents an alkyl group. In the case where R' in Formula (L-6) represents an alkyl group, the number of carbon atoms of the alkyl group is preferably in a range of 1 to 9, more preferably in a range of 4 to 9 from the viewpoints of chemical stability and carrier transportability, and still more preferably in a range of 5 to 9. In the case where R' in (L-6) represents an alkyl group, it is preferable that the alkyl group is a linear alkyl group from the viewpoint of improving the carrier transportability.

R^{N} represents a hydrogen atom or a substituent, and examples of R^{N} include those exemplified as the substituents which may be employed by R¹ to R⁸ in Formula (1) described below. Among these, it is preferable that R^{N} represents a hydrogen atom or a methyl group.

R^{si}'s each independently represent a hydrogen atom, an alkyl group, an alkenyl group, or an alkynyl group, and it is preferable that R^{si}'s represent an alkyl group. The alkyl group which may be employed by R^{si} is not particularly limited, but the preferable range of the alkyl group which may be employed by R^{si} is the same as the preferable range of an alkyl group which may be employed by a trialkylsilyl group in a case where R represents a trialkylsilyl group. The alkenyl group which may be employed as R^{si} is not particularly limited, but a substituted or unsubstituted alkenyl group is preferable and a branched alkenyl group is more preferable as the alkenyl group. The number of carbon atoms thereof is preferably 2 or 3. The alkynyl group which may be employed as R^{si} is not particularly limited, but a substituted or unsubstituted alkynyl group is preferable and a branched alkynyl group is more preferable as the alkynyl group. The number of carbon atoms thereof is preferably 2 or 3.

It is preferable that L represents a divalent linking group represented by any of Formulae (L-1) to (L-5), (L-13), (L-17), and (L-18) or a divalent linking group in which two or more divalent linking groups represented by any of Formulae (L-1) to (L-5), (L-13), (L-17), and (L-18) are bonded to each other, more preferable that L represents a divalent linking group represented by any of Formulae (L-1), (L-3), (L-13), and (L-18) or a divalent linking group in which two or more divalent linking groups represented by any of Formulae (L-1), (L-3), (L-13), and (L-18) are bonded to each other, and particularly preferable that L represents a divalent linking group represented by (L-1), (L-3), (L-13), or (L-18) or a divalent linking group in which a divalent linking group represented by any one of Formulae (L-3), (L-13), and (L-18) is bonded to a divalent linking group represented by Formula (L-1). In the divalent linking group in which a divalent linking group represented by any one of Formulae (L-3), (L-13), and (L-18) is bonded to a divalent linking group represented by Formula (L-1), it is preferable that the divalent linking group represented by Formula (L-1) is bonded to the R side. From the viewpoints of chemical stability and carrier transportability, it is particularly preferable that L represents a divalent linking group which has a divalent linking group represented by Formula (L-1), more particularly preferable that L represents a divalent linking group represented by Formula (L-1), and most preferable that L represents a divalent linking group represented by Formula (L-1) and R represents a substituted or unsubstituted alkyl group.

In Formula (W), R represents a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

In Formula (W), in a case where L adjacent to R represents a divalent linking group represented by Formula (L-1), it is preferable that R represents a substituted or unsubstituted alkyl group, an oxyethylene group, an oligooxyethylene group in which the repeating number of oxyethylene units is 2 or greater, a siloxane group, or an oligosiloxane group having 2 or more silicon atoms and more preferable that R represents a substituted or unsubstituted alkyl group.

In Formula (W), in a case where L adjacent to R represents a divalent linking group represented by any of Formulae (L-2) and (L-4) to (L-25), it is more preferable that R represents a substituted or unsubstituted alkyl group.

In Formula (W), in a case where L adjacent to R represents a divalent linking group represented by Formula (L-3), it is preferable that R represents a substituted or unsubstituted alkyl group or a substituted or unsubstituted silyl group.

In a case where R represents a substituted or unsubstituted alkyl group, the number of carbon atoms is preferably in a range of 4 to 17, more preferably in a range of 6 to 14 from the viewpoints of chemical stability and carrier transportability, and still more preferably in a range of 6 to 12. From the viewpoints of improving linearity of a molecule and carrier transportability, it is preferable that R represents a long-chain alkyl group, particularly a long-chain linear alkyl group, within the above-described range.

In a case where R represents an alkyl group, the alkyl group may be linear, branched, or cyclic, but it is preferable that the alkyl group is linear from the viewpoints of improving the linearity of a molecule and the carrier transportability.

As a combination of R and L of Formula (W), from the viewpoint of improving the carrier mobility, it is preferable that L in Formula (1) represents a divalent linking group represented by Formula (L-1) and R represents a linear alkyl group having 7 to 17 carbon atoms or L represents a divalent linking group in which a divalent linking group represented by any one of Formulae (L-3), (L-13), and (L-18) is bonded to a divalent linking group represented by Formula (L-1) and R represents a linear alkyl group.

In the case where L represents a divalent linking group represented by Formula (L-1) and R represents a linear alkyl group having 7 to 17 carbon atoms, it is more preferable that R represents a linear alkyl group having 7 to 14 carbon atoms from the viewpoint of improving the carrier mobility and particularly preferable that R represents a linear alkyl group having 7 to 12 carbon atoms.

In the case where L represents a divalent linking group in which a divalent linking group represented by any one of Formulae (L-3), (L-13), and (L-18) is bonded to a divalent linking group represented by Formula (L-1) and R represents a linear alkyl group, it is more preferable that R represents a linear alkyl group having 4 to 17 carbon atoms, more preferable that R represents a linear alkyl group having 6 to 14 carbon atoms from the viewpoints of the chemical stability and carrier mobility, and particularly preferable that R represents a linear alkyl group having 6 to 12 carbon atoms from the viewpoint of improving the carrier mobility.

Meanwhile, from the viewpoint of improving solubility in an organic solvent, it is preferable that R represents a branched alkyl group.

In a case where R represents an alkyl group having a substituent, a halogen atom may be exemplified as the substituent and a fluorine atom is preferable. Moreover, in a case where R represents an alkyl group having fluorine atoms, all hydrogen atoms of the alkyl group may be substituted with fluorine atoms to form a perfluoroalkyl group. In this case, it is preferable that R represents an unsubstituted alkyl group.

In a case where R represents an oligoethyleneoxy group in which the repeating number of oxyethylene groups is 2 or greater, the "oligooxyethylene group" represented by R indicates a group represented by -(OCH₂CH₂)ᵥOY (the repeating number v of oxyethylene units is an integer of 2 or greater and Y at the terminal represents a hydrogen atom or a substituent). Further, in a case where Y at the terminal of the oligooxyethylene group represents a hydrogen atom, this becomes a hydroxy group. The repeating number v of the oxyethylene units is preferably in a range of 2 to 4 and more preferably 2 or 3. It is preferable that the hydroxy group at the terminal of the oligooxyethylene group is sealed, that is, Y represents a substituent. In this case, it is preferable that the hydroxy group is sealed by an alkyl group having 1 to 3 carbon atoms, that is, Y represents an alkyl group having 1 to 3 carbon atoms, more preferable that Y represents a methyl group or an ethyl group, and particularly preferable that Y represents a methyl group.

In a case where R represents a siloxane group or an oligosiloxane group having 2 or more silicon atoms, the repeating number of siloxane units is preferably 2 to 4 and more preferably 2 or 3. Further, it is preferable that a hydrogen atom or an alkyl group is bonded to a silicon atom (Si atom). In a case where an alkyl group is bonded to a silicon atom, the number of carbon atoms of the alkyl group is preferably in a range of 1 to 3, and it is preferable that a methyl group or an ethyl group is bonded to the silicon atom. The same alkyl groups may be bonded to a silicon atom or alkyl groups which are different from each other or hydrogen atoms may be bonded thereto. In addition, all siloxane units constituting an oligosiloxane group may be the same as or different from each other, but it is preferable that all siloxane units are the same as each other.

In a case where L adjacent to R represents a divalent linking group represented by Formula (L-3), it is also preferable that R represents a substituted or unsubstituted trialkylsilyl group. In the case where R represents a substituted or unsubstituted trialkylsilyl group, it is preferable that R represents a substituted trialkylsilyl group. The substituent of the trialkylsilyl group is not particularly limited as long as the substituent is a substituted or unsubstituted alkyl group, but a branched alkyl group is more preferable as the substituent. The number of carbon atoms of an alkyl group bonded to a Si atom is preferably in a range of 1 to 3, and it is preferable that a methyl group, an ethyl group, or an isopropyl group is bonded to a Si atom. Alkyl groups which are the same as or different from each other may be bonded to a silicon atom. In a case where R represents a trialkylsilyl group having other substituents on an alkyl group, the substituents are not particularly limited.

In Formula (W), the total number of carbon atoms included in L and R is preferably in a range of 5 to 18. When the total number of carbon atoms included in L and R is greater than or equal to the lower limit of the above-described range, the carrier mobility is increased and the driving voltage is lowered. The total number of carbon atoms included in L and R is less than or equal to the upper limit of the above-described range, the solubility in an organic solvent is increased.

The total number of carbon atoms included in L and R is preferably in a range of 5 to 14, more preferably in a range of 6 to 14, particularly preferably in a range of 6 to 12, and most preferably in a range of 8 to 12.

### (Compound represented by Formula (1)) (not forming part of the present invention)

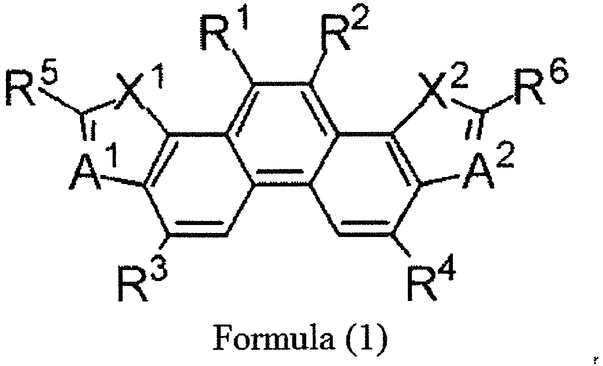

In Formula (1), X¹ and X² represent a S atom.

In Formula (1), A¹ represents CR⁷ or a N atom, A² represents CR⁸ or a N atom, and R⁷ and R⁸ each independently represent a hydrogen atom or a substituent. It is preferable that A¹ represents CR⁷ or A² represents CR⁸ and more preferable that A¹ represents CR⁷ and A² represents CR⁸. A¹ and A² may be the same as or different from each other, but it is preferable that A¹ and A² are the same as each other.

In formula (1), R⁵ and R⁷ may or may not form a ring after being bonded to each other, but it is preferable that R⁵ and R⁷ do not form a ring after being bonded to each other.

In formula (1), R⁶ and R⁸ may or may not form a ring after being bonded to each other, but it is preferable that R⁶ and R⁸ do not form a ring after being bonded to each other.

In Formula (1), R¹ to R⁸ each independently represent a hydrogen atom or a substituent. It is preferable that at least one of R¹, R², ..., or R⁸ represents a substituent represented by Formula (W).

The substituents W described below may be exemplified as the substituents which can be independently represented by each of R¹ to R⁸. Examples of the substituents W include a halogen atom, an alkyl group (such as a cycloalkyl group, a bicycloalkyl group, or a tricycloalkyl group), an alkenyl group (such as a cycloalkenyl group or a bicycloalkenyl group), an alkynyl group, an aryl group, a heterocyclic group, a cyano group, a hydroxy group, a nitro group, a carboxy group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (such as an anilino group), an ammonio group, an acylamino group, an aminocarbonylamino group, an alkoxycarbonylamino group, an aryloxycarbonylamino group, a sulfamoylamino group, an alkyl- or aryl-sulfonylamino group, a mercapto group, an alkylthio group, an arylthio group, a heterocyclic thio group, a sulfamoyl group, a sulfo group, an alkyl- and aryl-sulfinyl group, an alkyl- and aryl-sulfonyl group, an acyl group, an aryloxycarbonyl group, an alkoxycarbonyl group, a carbamoyl group, an aryl- and heterocyclic-azo group, an imido group, a phosphino group, a phosphinyl group, a phosphinyloxy group, a phosphinylamino group, a phosphono group, a silyl group, a hydrazino group, an ureido group, a boronic acid group (-B(OH)₂), a phosphato group (-OPO(OH)₂), a sulfato group(-OSO₃H), and other known substituents. Further, in the present invention, preferable examples of the "substituent" include the above-described substituents W.

As the substituents which may be independently represented by each of the R¹ to R⁸, an alkyl group, an aryl group, an alkenyl group, an alkynyl group, a heterocyclic group, an alkoxy group, an alkylthio group, and a substituent represented by Formula (W) are preferable, an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, and a substituent represented by Formula (W) are more preferable, a group having a linking group chain length of 3.7 Å or less described below and a substituent represented by Formula (W) are particularly preferable, and a substituent represented by Formula (W) is more particularly preferable.

Among R¹ to R⁸ in compounds represented by Formulae (1), the number of substituents represented by Formula (W) is preferably in a range of 1 to 4 from the viewpoints of improving the carrier mobility and the solubility in an organic solvent, more preferably 1 or 2, and particularly preferably 2.

Among R¹ to R⁸, the position of substituents represented by Formula (W) is not particularly limited, but it is preferable that the position thereof is R⁵ or R⁶ from the viewpoints of improving the carrier mobility and the solubility in an organic solvent.

Among R¹ to R⁸, the number of substituents other than the substituents represented by Formula (W) is preferably in a range of 0 to 4, more preferably in a range of 0 to 2, particularly preferably 0 to 1, and more particularly preferably 0.

As a substituent in a case where R¹ to R⁸ represent a substituent other than the substituents represented by Formula (W), a group having a linking group chain length of 3.7 Å or less is preferable, a group having a linking group chain length of 1.0 Å to 3.7 Å is more preferable, and a group having a linking group chain length of 1.0 Å to 2.1 Å is still more preferable.

Here, the linking group chain length indicates the length from a carbon atom (C atom) to the terminal of a substituent R in a C-R bond. The structurer optimization calculation can be performed using a density functional method (Gaussian03 (Gaussian, Inc.)/basis function: 6-31G*, exchange-correlation functional: B3LYP/LANL2DZ). As molecular lengths of typical substituents, a propyl group is 4.6 Å, a pyrrole group is 4.6 Å, a propynyl group is 4.5 A, a propenyl group is 4.6 Å, an ethoxy group is 4.5 Å, a methylthio group is 3.7 Å, an ethenyl group is 3.4 Å, an ethyl group is 3.5 Å, an ethynyl group is 3.6 Å, a methoxy group is 3.3 Å, a methyl group is 2.1 Å, and a hydrogen atom is 1.0 Å.

As a substituent in the case where R¹ to R⁸ each independently represent a substituent other than the substituents represented by Formula (W), a substituted or unsubstituted alkyl group having 2 or less carbon atoms, a substituted alkynyl group having 2 or less carbon atoms, a substituted or unsubstituted alkenyl group having 2 or less carbon atoms, or a substituted or unsubstituted acyl group having 2 or less carbon atoms is preferable, and a substituted or unsubstituted alkyl group having 2 or less carbon atoms is more preferable.

In a case where substituents, represented by R¹ to R⁸, other than the substituents represented by Formula (W) each independently represent a substituted alkyl group having 2 or less carbon atoms, examples of the substituent which can be employed by an alkyl group include a cyano group, a fluorine atom, and a deuterium atom. Among these, a cyano group is preferable. As a substituted or unsubstituted alkyl group having 2 or less carbon atoms, which is represented by a substituent in a case where R¹ to R⁸ each independently represent a substituent other than the substituents represented by Formula (W), a methyl group, an ethyl group, or a cyano group-substituted methyl group is preferable, a methyl group or a cyano group-substituted methyl group is more preferable, and a cyano group-substituted methyl group is particularly preferable.

In a case where substituents, represented by R¹ to R⁸, other than the substituents represented by Formula (W) each independently represent a substituted alkynyl group having 2 or less carbon atoms, examples of the substituent which can be employed by an alkynyl group include a deuterium atom. As a substituted or unsubstituted alkynyl group having 2 or less carbon atoms, which is represented by a substituent in a case where R¹ to R⁸ each independently represent a substituent other than the substituents represented by Formula (W), an ethynyl group and a deuterium atom-substituted acetylene group may be exemplified. Among these, an ethynyl group is preferable.

In a case where substituents, represented by R¹ to R⁸, other than the substituents represented by Formula (W) each independently represent a substituted alkenyl group having 2 or less carbon atoms, examples of the substituent which can be employed by an alkenyl group include a deuterium atom. As a substituted or unsubstituted alkenyl group having 2 or less carbon atoms, which is represented by a substituent in a case where R¹ to R⁸ each independently represent a substituent other than the substituents represented by Formula (W), an ethenyl group and a deuterium atom-substituted ethenyl group may be exemplified. Among these, an ethenyl group is preferable.

In a case where substituents, represented by R¹ to R⁸, other than the substituents represented by Formula (W) each independently represent a substituted acyl group having 2 or less carbon atoms, examples of the substituent which can be employed by an acyl group include a fluorine atom. As a substituted or unsubstituted acyl group having 2 or less carbon atoms, which is represented by a substituent in a case where R¹ to R⁸ each independently represent a substituent other than the substituents represented by Formula (W), a formyl group, an acetyl group, or a fluorine-substituted acetyl group may be exemplified. Among these, a formyl group is preferable.

As the compound represented by Formula (1), a compound represented by the following Formula (1A) or (1B) is preferable and a compound represented by Formula (1A) is particularly preferable from the viewpoint of high mobility. None of compounds represented by formula (1A) or (1B) are forming part of the present invention.

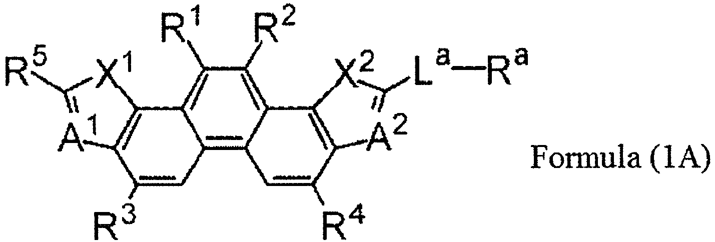

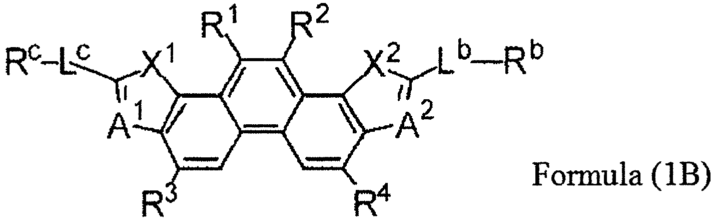

In Formula (1A), X¹ and X² represent a S atom, A¹ represents CR⁷ or a N atom, A² represents CR⁸ or a N atom, R¹ to R⁵, R⁷, and R⁸ each independently represent a hydrogen atom or a substituent, R⁵ does not represent a group represented by -L^{a}-R^{a}, L^{a} represents a divalent linking group represented by any of the above-described Formulae (L-1) to (L-25) or a divalent linking group formed by two or more divalent linking groups, represented by any of the above-described Formulae (L-1) to (L-25), being bonded to each other, and R^{a} represents a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

Examples of the substituents represented by R¹ to R⁵, R⁷, and R⁸ include the above-described substituents W.

In Formula (1B), X¹ and X² represent a S atom, A¹ represents CR⁷ or a N atom, A² represents CR⁸ or a N atom, R¹ to R⁴, R⁷, and R⁸ each independently represent a hydrogen atom or a substituent, L^{b} and L^{c} each independently represent a divalent linking group represented by any of the above-described Formulae (L-1) to (L-25) or a divalent linking group formed by two or more divalent linking groups, represented by any of the above-described Formulae (L-1) to (L-25), being bonded to each other, and R^{b} and R^{c} each independently represent a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

Examples of the substituents represented by R¹ to R⁴, R⁷, and R⁸ include the above-described substituents W.

### (Compound represented by Formula (2)) (not forming part of the present invention)

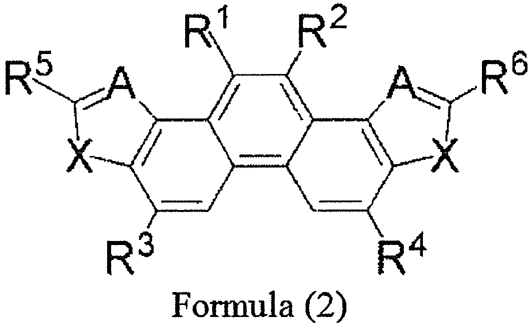

In Formula (2), R¹ to R⁶ and R⁸ described below each independently represent a hydrogen atom or a substituent. Further, it is preferable that at least one of R¹, R², ..., R⁶, or R⁸ represents a substituent represented by Formula (W).

Examples of the substituents represented by R¹ to R⁶ and R⁸ include the above-described substituents W. The definitions of the substituents represented by Formula (W) are as described above.

As the substituents which can be independently represented by each of R¹ to R⁶ and R⁸, an alkyl group, an aryl group, an alkenyl group, an alkynyl group, a heterocyclic group, an alkoxy group, an alkylthio group, and a substituent represented by Formula (W) are preferable, and an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, and a substituent represented by Formula (W) are more preferable.

In Formula (2), X represents a S atom.

In Formula (2), A's each independently represent CR⁸ or a N atom, and it is preferable that A's represent CR⁸. In Formula (2), two A's may be the same as or different from each other, but it is preferable that A's are the same as each other.

R⁸ represents preferably a group having a linking group chain length of 3.7 Å or less, more preferably a group having a linking group chain length of 1.0 Å to 3.7 Å, and still more preferably a group having a linking group chain length of 1.0 Å to 2.1 Å. The definition of the linking group chain length is as described above.

R⁸ represents preferably a hydrogen atom, a substituted or unsubstituted alkyl group having 2 or less carbon atoms, a substituted or unsubstituted alkynyl group having 2 or less carbon atoms, a substituted or unsubstituted alkenyl group alkenyl group having 2 or less carbon atoms, or a substituted or unsubstituted acyl group having 2 or less carbon atoms, more preferably a hydrogen atom or a substituted or unsubstituted alkyl group having 2 or less carbon atoms, and particularly preferably a hydrogen atom.

In a case where R⁸ represents a substituted alkyl group having 2 or less carbon atoms, examples of the substituent which can be employed by an alkyl group include a cyano group, a fluorine atom, and a deuterium atom. Among these, a cyano group is preferable. As a substituted or unsubstituted alkyl group having 2 or less carbon atoms, which is represented by R⁸, a methyl group, an ethyl group, or a cyano group-substituted methyl group is preferable, a methyl group or a cyano group-substituted methyl group is more preferable, and a cyano group-substituted methyl group is particularly preferable.

In a case where R⁸ represents a substituted alkynyl group having 2 or less carbon atoms, examples of the substituent which can be employed by an alkynyl group include a deuterium atom. As a substituted or unsubstituted alkynyl group having 2 or less carbon atoms, which is represented by R⁸, an ethynyl group or a deuterium atom may be exemplified. Among these, an ethynyl group is preferable.

In a case where R⁸ represents a substituted alkenyl group having 2 or less carbon atoms, examples of the substituent which can be employed by an alkenyl group include a deuterium atom. As a substituted or unsubstituted alkenyl group having 2 or less carbon atoms, which is represented by R⁸, an ethenyl group or a deuterium atom may be exemplified. Among these, an ethenyl group is preferable.

In a case where R⁸ represents a substituted acyl group having 2 or less carbon atoms, examples of the substituent which can be employed by an acyl group include a fluorine atom. As a substituted or unsubstituted acyl group having 2 or less carbon atoms, which is represented by R⁸, a formyl group, an acetyl group, or a fluorine-substituted acetyl group may be exemplified. Among these, a formyl group is preferable.

As the compound represented by Formula (2), a compound represented by Formula (2A) or (2B) is preferable, a compound represented by Formula (2A) is particularly preferable from the viewpoint of high solubility, and a compound represented by Formula (2B) is also particularly preferable from the viewpoint of high mobility. None of compounds represented by formula (2A) or (2B) are forming part of the present invention.

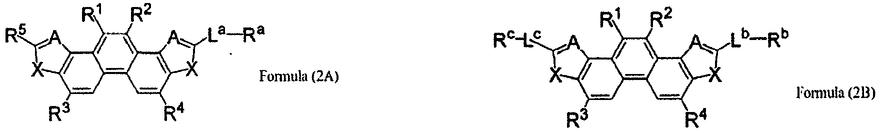

In Formula (2A), X represents a S atom, A's each independently represents CR⁸ or a N atom, R¹ to R⁵, and R⁸ each independently represent a hydrogen atom or a substituent. In this case, R⁵ does not represent a group represented by -L^{a}-R^{a}.

L^{a} each independently represents a divalent linking group represented by any of the above-described Formulae (L-1) to (L-25) or a divalent linking group formed by two or more divalent linking groups, represented by any of the above-described Formulae (L-1) to (L-25), being bonded to each other, and R^{a} each independently represents a hydrogen atom, a substituted or unsubstituted alkyl group, an oligooxyethylene group in which the repeating number v of oxyethylene units is 2 or greater, an oligosiloxane group having 2 or more silicon atoms, or a substituted or unsubstituted trialkylsilyl group.

In Formula (2B), X represents a S atom, A's each independently represents CR⁸ or a N atom, R¹ to R⁴, and R⁸ each independently represent a hydrogen atom or a substituent. L^{b} and L^{c} each independently represent a divalent linking group represented by any of the above-described Formulae (L-1) to (L-25) or a divalent linking group formed by two or more divalent linking groups, represented by any of the above-described Formulae (L-1) to (L-25), being bonded to each other, and R^{b} and R^{c} each independently represent a hydrogen atom, a substituted or unsubstituted alkyl group, an oligooxyethylene group in which the repeating number v of oxyethylene units is 2 or greater, an oligosiloxane group having 2 or more silicon atoms, or a substituted or unsubstituted trialkylsilyl group.

### (Compound represented by Formula (3)) (not forming part of the present invention)

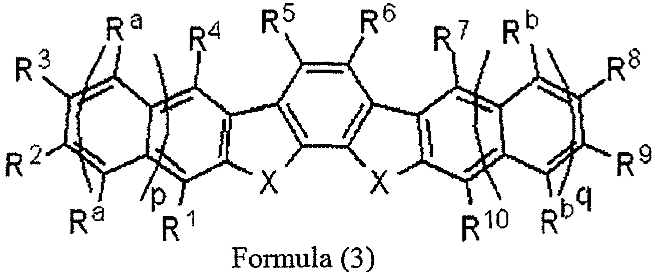

In Formula (3), X represents a S atom.

In Formula (3), p and q each independently represent an integer of 0 to 2. It is preferable that p and q each independently represent 0 or 1 from the viewpoint of achieving both of mobility and solubility and more preferable that both of p and q represent 0 or 1.

In Formula (3), R¹ to R¹⁰, R^{a}, and R^{b} each independently represent a hydrogen atom, a halogen atom, or a substituent represented by Formula (W). Here, in a case where at least one of R⁵ or R⁶ represents a substituent represented by Formula (W), L in Formula (W), which is represented by R⁵ and R⁶, represents a divalent linking group represented by the above-described Formula (L-2) or (L-3). Further, at least one of R¹ to R¹⁰, R^{a}, or R^{b} represents a substituent represented by Formula (W). The definitions of the substituents represented by Formula (W) are as described above.

A case where at least one of R⁵ or R⁶ represents a substituent represented by Formula (W) corresponds to a case where any one of R⁵ and R⁶ does not represent a hydrogen atom or a halogen atom.

In the case where at least one of R⁵ or R⁶ represents a substituent represented by Formula (W), it is preferable that L in Formula (W), which is represented by R⁵ and R⁶, represents a divalent linking group represented by the above-described Formula (L-3).

In the case where at least one of R⁵ or R⁶ represents a substituent represented by Formula (W), it is preferable that both of R⁵ and R⁶ represent a substituent represented by Formula (W).

Further, in a case where both of R⁵ and R⁶ represent a hydrogen atom or a halogen atom, R¹ to R⁴, R⁷ to R¹⁰, R^{a}, and R^{b} each independently represent a hydrogen atom, a halogen atom, or a substituent represented by Formula (W) and at least one of R¹ to R⁴, R⁷ to R¹⁰, R^{a}, or R^{b} represents a substituent represented by Formula (W).

In Formula (3), examples of the halogen atom represented by R¹ to R¹⁰, R^{a}, and R^{b} include a fluorine atom, a chlorine atom, a bromine atom, and an iodine atom. Among these, a fluorine atom, a chlorine atom, or a bromine atom is preferable, a fluorine atom or a chlorine atom is more preferable, and a fluorine atom is particularly preferable.

Among R¹ to R¹⁰, R^{a}, and R^{b} in compounds represented by Formula (3), the number of halogen atoms is preferably in a range of 0 to 4, more preferably in a range of 0 to 2, particularly preferably 0 or 1, and more particularly preferably 0.

Among R¹ to R¹⁰, R^{a}, and R^{b} in compounds represented by Formulae (3), the number of substituents represented by Formula (W) is preferably in a range of 1 to 4 from the viewpoints of improving the carrier mobility and the solubility in an organic solvent, more preferably 1 or 2, and particularly preferably 2.

Among R¹ to R¹⁰, R^{a}, and R^{b}, the position of substituents represented by Formula (W) is not particularly limited. According to the present invention, in Formula (4), it is preferable R¹, R⁴ to R⁷, R¹⁰, R^{a}, and R^{b} each independently represent a hydrogen atom or a halogen atom, R², R³, R⁸, and R⁹ each independently represent a hydrogen atom, a halogen atom, or a substituent represented by Formula (W), and at least one of R², R³, R⁸, or R⁹ represents a substituent represented by Formula (W) from the viewpoints of improving the carrier mobility and the solubility in an organic solvent.

In the present invention, it is more preferable that R¹, R³ to R⁸, and R¹⁰ each independently represent a hydrogen atom or a halogen atom, R² and R⁹ each independently represent a hydrogen atom, a halogen atom, or a substituent represented by Formula (W), and at least one of R² or R⁹ represents a substituent represented by Formula (W).

In the present invention, it is particularly preferable that both of R² and R⁹ represent a substituent represented by Formula (W) and both of R³ and R⁸ represent a hydrogen atom or a halogen atom; or both of R³ and R⁸ represent a substituent represented by Formula (W) and both of R² and R⁹ represent a hydrogen atom or a halogen atom.

In the present invention, it is more particularly preferable that both of R² and R⁹ represent a substituent represented by Formula (W) and both of R³ and R⁸ represent a hydrogen atom or a halogen atom; or both of R³ and R⁸ represent a substituent represented by Formula (W) and both of R² and R⁹ represent a hydrogen atom or a halogen atom.

In Formula (3), two or more from among R¹ to R¹⁰, R^{a}, and R^{b} may or may not form a ring after being bonded to each other, but it is preferable that the two or more do not form a ring after being bonded to each other.

It is preferable that the compound represented by Formula (3) is a compound represented by the following Formula (3A) or (3B) and particularly preferable that the compound represented by Formula (3) is a compound represented by the following Formula (3A) from the viewpoint of achieving both of high carrier mobility and high solubility. None of the compounds represented by Formula (3A) or (3B) is part of the present invention.

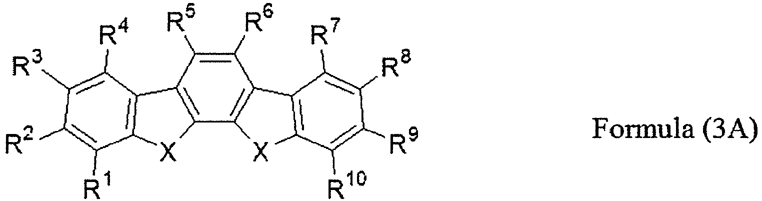

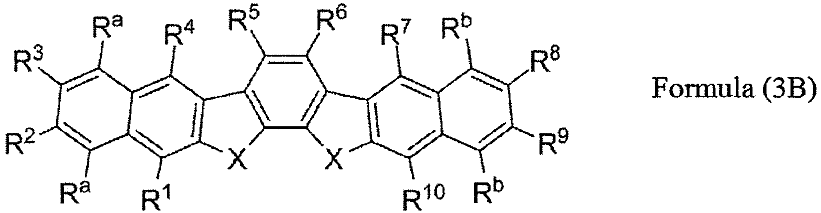

In Formula (3A), X represents a S atom, R¹, R³ to R⁸, and R¹⁰ each independently represent a hydrogen atom or a halogen atom, R² and R⁹ each independently represent a hydrogen atom, a halogen atom, or a substituent represented by Formula (W), and at least one of R² or R⁹ represents a substituent represented by Formula (W). Here, in a case where the substituent represented by Formula (W) is an alkyl group, the substituent represented by Formula (W) is limited to a linear alkyl group having 4 to 18 carbon atoms or a branched alkyl group having 4 or more carbon atoms.

In Formula (3B), X represents a S atom, R¹, R⁴ to R⁷, R¹⁰, R^{a}, and R^{b} each independently represent a hydrogen atom or a halogen atom, R², R³, R⁸, and R⁹ each independently represent a hydrogen atom, a halogen atom, or a substituent represented by Formula (W), and at least one of R², R³, R⁸, or R⁹ represents a substituent represented by Formula (W).

### (Compound represented by Formula (4)) (not forming part of the present invention)

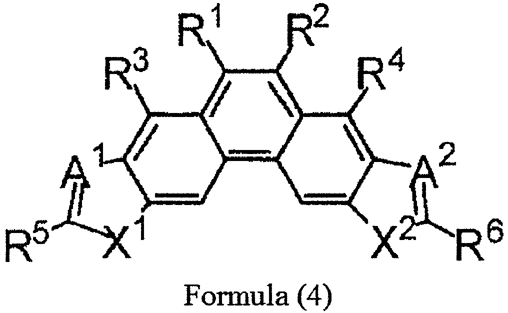

In Formula (4), X¹ and X² represent a S atom.

In Formula (4), A¹ represents CR⁷ or a N atom, A² represents CR⁸ or a N atom, R⁷ and R⁸ each independently represent a hydrogen atom or a substituent. It is preferable that A¹ represents CR⁷ or A² represents CR⁸ and more preferable that A¹ represents CR⁷ and A² represents CR⁸. A¹ and A² may be the same as or different from each other, but it is preferable that A¹ and A² are the same as each other.

In formula (4), R⁵ and R⁷ may or may not form a ring after being bonded to each other, but it is preferable that R⁵ and R⁷ do not form a ring after being bonded to each other.

In formula (4), R⁶ and R⁸ may or may not form a ring after being bonded to each other, but it is preferable that R⁶ and R⁸ do not form a ring after being bonded to each other.

In Formula (4), R¹ to R⁸ each independently represent a hydrogen atom or a substituent. Further, it is preferable that at least one of R¹, R², ..., or R⁸ represents a substituent represented by Formula (W).

Examples of the substituents represented by R¹ to R⁸ include the substituents W. The definitions of the substituents represented by Formula (W) are as described above.

Among R¹ to R⁸ in compounds represented by Formulae (4), the number of substituents represented by Formula (W) is preferably in a range of 1 to 4 from the viewpoints of improving the carrier mobility and the solubility in an organic solvent, more preferably 1 or 2, and particularly preferably 2.

Among R¹ to R⁸, the position of substituents represented by Formula (W) is not particularly limited, but it is preferable that the position thereof is R⁵ or R⁶ from the viewpoints of improving the carrier mobility and the solubility in an organic solvent.

Among R¹ to R⁸, the number of substituents other than the substituents represented by Formula (W) is preferably in a range of 0 to 4, more preferably in a range of 0 to 2, particularly preferably 0 to 1, and more particularly preferably 0.

As a substituent in a case where R¹ to R⁸ represent a substituent other than the substituents represented by Formula (W), a group having a linking group chain length of 3.7 Å or less is preferable, a group having a linking group chain length of 1.0 Å to 3.7 Å is more preferable, and a group having a linking group chain length of 1.0 Å to 2.1 Å is still more preferable. The definition of the linking group chain length is as described above.

As a substituent in the case where R¹ to R⁸ each independently represent a substituent other than the substituents represented by Fonnula (W), a substituted or unsubstituted alkyl group having 2 or less carbon atoms, a substituted alkynyl group having 2 or less carbon atoms, a substituted or unsubstituted alkenyl group having 2 or less carbon atoms, or a substituted or unsubstituted acyl group having 2 or less carbon atoms is preferable, and a substituted or unsubstituted alkyl group having 2 or less carbon atoms is more preferable.

In a case where substituents, represented by R¹ to R⁸, other than the substituents represented by Formula (W) each independently represent a substituted alkyl group having 2 or less carbon atoms, examples of the substituent which can be employed by an alkyl group include a cyano group, a fluorine atom, and a deuterium atom. Among these, a cyano group is preferable.

As a substituted or unsubstituted alkyl group having 2 or less carbon atoms, which is represented by a substituent in a case where R¹ to R⁸ each independently represent a substituent other than the substituents represented by Formula (W), a methyl group, an ethyl group, or a cyano group-substituted methyl group is preferable, a methyl group or a cyano group-substituted methyl group is more preferable, and a cyano group-substituted methyl group is particularly preferable.

In a case where substituents, represented by R¹ to R⁸, other than the substituents represented by Formula (W), each independently represent a substituted alkynyl group having 2 or less carbon atoms, examples of the substituent which can be employed by an alkynyl group include a deuterium atom. As a substituted or unsubstituted alkynyl group having 2 or less carbon atoms, which is represented by a substituent in a case where R¹ to R⁸ each independently represent a substituent other than the substituents represented by Formula (W), an ethynyl group and a deuterium atom-substituted acetylene group may be exemplified. Among these, an ethynyl group is preferable.

In a case where substituents, represented by R¹ to R⁸, other than the substituents represented by Formula (W), each independently represent a substituted alkenyl group having 2 or less carbon atoms, examples of the substituent which can be employed by an alkenyl group include a deuterium atom. As a substituted or unsubstituted alkenyl group having 2 or less carbon atoms, which is represented by a substituent in a case where R¹ to R⁸ each independently represent a substituent other than the substituents represented by Formula (W), an ethenyl group and a deuterium atom-substituted ethenyl group may be exemplified. Among these, an ethenyl group is preferable.

In a case where substituents, represented by R¹ to R⁸, other than the substituents represented by Formula (W), each independently represent a substituted acyl group having 2 or less carbon atoms, examples of the substituent which can be employed by an acyl group include a fluorine atom. As a substituted or unsubstituted acyl group having 2 or less carbon atoms, which is represented by a substituent in a case where R¹ to R⁸ each independently represent a substituent other than the substituents represented by Formula (W), a formyl group, an acetyl group, or a fluorine-substituted acetyl group may be exemplified. Among these, a formyl group is preferable.

As the compound represented by Formula (4), a compound represented by the following Formula (4A) or (4B) is preferable and a compound represented by Formula (4A) is particularly preferable from the viewpoint of high mobility. None of compounds represented by Formula (4A) or (4B) are part of the present invention.

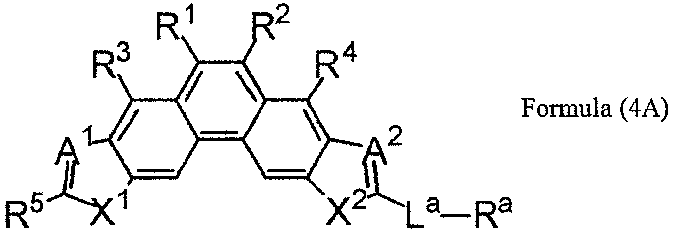

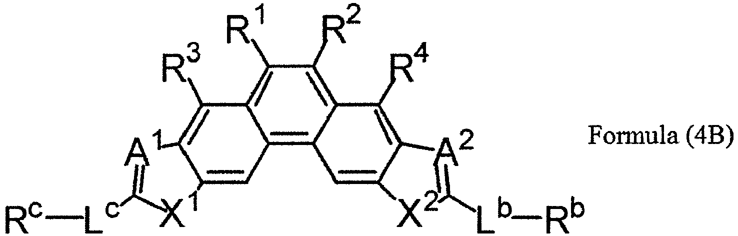

In Formula (4A), X¹ and X² represent a S atom, A¹ represents CR⁷ or a N atom, A² represents CR⁸ or a N atom. A¹, A², R⁷, and R⁸ in Formula (4A) have the same definitions as those for A¹, A², R⁷, and R⁸ in Formula (4).

In Formula (4A), R¹ to R⁵, R⁷, and R⁸ each independently represent a hydrogen atom or a substituent, R⁵ does not represent a group represented by -L^{a}-R^{a}.

In a case where R¹ to R⁵, R⁷, and R⁸ in Formula (4A) represent a substituent, the preferable ranges of the substituent are the same as the preferable ranges in the case where R¹ to R⁸ in Formula (4) represent a substituent other than the substituents represented by Formula (W).

In Formula (4A), L^{a} represents a divalent linking group represented by any of the above-described Formulae (L-1) to (L-25) or a divalent linking group formed by two or more divalent linking groups, represented by any of the above-described Formulae (L-1) to (L-25), being bonded to each other, and R^{a} represents a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

In Formula (4B), X¹ and X² represent a S atom, A¹ represents CR⁷ or a N atom, A² represents CR⁸ or a N atom. A¹, A², R⁷, and R⁸ in Formula (4B) have the same definitions as those for A¹, A², R⁷, and R⁸ in Formula (4).

In Formula (4B), R¹ to R⁴, R⁷, and R⁸ each independently represent a hydrogen atom or a substituent. In a case where R¹ to R⁴, R⁷, and R⁸ in Formula (4B) represent a substituent, the preferable ranges of the substituent are the same as the preferable ranges in the case where R¹ to R⁸ in Formula (4) represent a substituent other than the substituents represented by Formula (W).

In Formula (4B), L^{b} and L^{c} each independently represent a divalent linking group represented by any of Formulae (L-1) to (L-25) or a divalent linking group formed by two or more divalent linking groups, represented by any of Formulae (L-1) to (L-25), being bonded to each other, and R^{b} and R^{c} each independently represent a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

### (Compound represented by Formula (5))

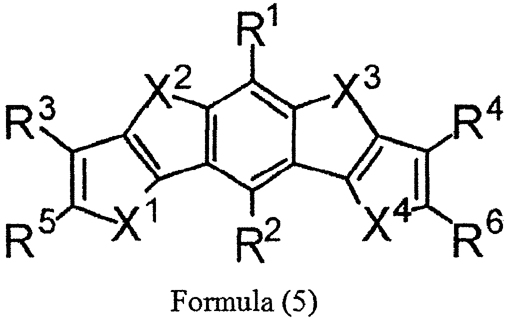

In Formula (5), X¹ to X⁴ represent a S atom.

In Formula (5) R¹ to R⁶ each independently represent a hydrogen atom or a substituent. Further, it is preferable that at least one of R¹, R², ..., or R⁶ represents a substituent represented by Formula (W).

Examples of the substituents represented by R¹ to R⁶ include the substituents W. The definitions of the substituents represented by Formula (W) are as described above.

As the substituents which can be independently represented by each of R¹ to R⁶, an alkyl group, an aryl group, an alkenyl group, an alkynyl group, a heterocyclic group, an alkoxy group, an alkylthio group, and a substituent represented by Formula (W) are preferable, and an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, a substituent represented by Formula (W) are more preferable, a group having a linking group chain length of 3.7 Å or less described below and a substituent represented by Formula (W) are particularly preferable, and a substituent represented by Formula (W) is more particularly preferable.

Among R¹ to R⁶ in compounds represented by Formulae (5), the number of substituents represented by Formula (W) is preferably in a range of 1 to 4 from the viewpoints of improving the carrier mobility and the solubility in an organic solvent, more preferably 1 or 2, and particularly preferably 2.

Among R¹ to R⁶, the position of substituents represented by Formula (W) is not particularly limited, but it is preferable that the position thereof is any of R³ to R⁶ and more preferable that the position thereof is R⁵ or R⁶ from the viewpoints of improving the carrier mobility and the solubility in an organic solvent.

Among R¹ to R⁶, the number of substituents other than the substituents represented by Formula (W) is preferably in a range of 0 to 4, more preferably in a range of 0 to 2, particularly preferably 0 to 1, and more particularly preferably 0.

As a substituent in a case where R¹ to R⁶ represent a substituent other than the substituents represented by Formula (W), a group having a linking group chain length of 3.7 Å or less is preferable, a group having a linking group chain length of 1.0 Å to 3.7 Å is more preferable, and a group having a linking group chain length of 1.0 Å to 2.1 Å is still more preferable. The definition of the linking group chain length is as described above.

As a substituent in the case where R¹ to R⁶ each independently represent a substituent other than the substituents represented by Formula (W), a substituted or unsubstituted alkyl group having 2 or less carbon atoms, a substituted alkynyl group having 2 or less carbon atoms, a substituted or unsubstituted alkenyl group having 2 or less carbon atoms, or a substituted or unsubstituted acyl group having 2 or less carbon atoms is preferable, and a substituted or unsubstituted alkyl group having 2 or less carbon atoms is more preferable.

In a case where substituents, represented by R¹ to R⁶, other than the substituents represented by Formula (W) each independently represent a substituted alkyl group having 2 or less carbon atoms, examples of the substituent which can be employed by an alkyl group include a cyano group, a fluorine atom, and a deuterium atom. Among these, a cyano group is preferable. As a substituted or unsubstituted alkyl group having 2 or less carbon atoms, which is represented by a substituent in a case where R¹ to R⁶ each independently represent a substituent other than the substituents represented by Formula (W), a methyl group, an ethyl group, or a cyano group-substituted methyl group is preferable, a methyl group or a cyano group-substituted methyl group is more preferable, and a cyano group-substituted methyl group is particularly preferable.

In a case where substituents, represented by R¹ to R⁶, other than the substituents represented by Formula (W) each independently represent a substituted alkynyl group having 2 or less carbon atoms, examples of the substituent which can be employed by an alkynyl group include a deuterium atom. As a substituted or unsubstituted alkynyl group having 2 or less carbon atoms, which is represented by a substituent in a case where R¹ to R⁶ each independently represent a substituent other than the substituents represented by Formula (W), an ethynyl group and a deuterium atom-substituted acetylene group may be exemplified. Among these, an ethynyl group is preferable.

In a case where substituents, represented by R¹ to R⁶, other than the substituents represented by Formula (W) each independently represent a substituted alkenyl group having 2 or less carbon atoms, examples of the substituent which can be employed by an alkenyl group include a deuterium atom. As a substituted or unsubstituted alkenyl group having 2 or less carbon atoms, which is represented by a substituent in a case where R¹ to R⁶ each independently represent a substituent other than the substituents represented by Formula (W), an ethenyl group and a deuterium atom-substituted ethenyl group may be exemplified. Among these, an ethenyl group is preferable.

In a case where substituents, represented by R¹ to R⁶, other than the substituents represented by Formula (W) each independently represent a substituted acyl group having 2 or less carbon atoms, examples of the substituent which can be employed by an acyl group include a fluorine atom. As a substituted or unsubstituted acyl group having 2 or less carbon atoms, which is represented by a substituent in a case where R¹ to R⁶ each independently represent a substituent other than the substituents represented by Formula (W), a formyl group, an acetyl group, or a fluorine-substituted acetyl group may be exemplified. Among these, a formyl group is preferable.

As the compound represented by Formula (5), a compound represented by the following Formula (5A) or (5B) is preferable and a compound represented by Formula (5A) is particularly preferable from the viewpoint of high mobility.

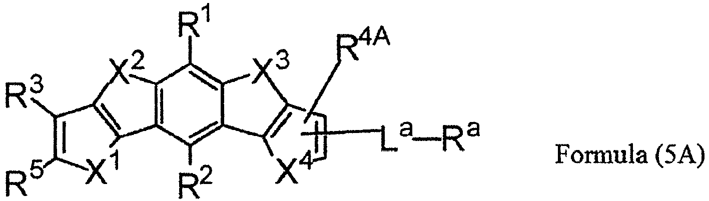

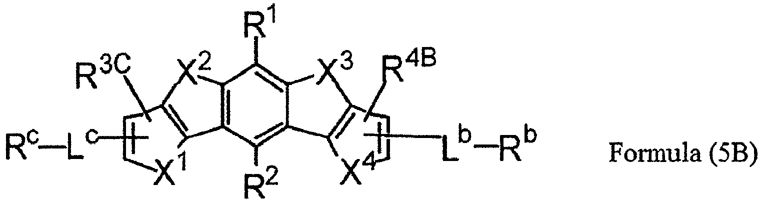

In Formula (5A), X¹ to X⁴ represent a S atom, R¹ to R³, R^{4A}, and R⁵ each independently represent a hydrogen atom or a substituent, R¹ to R³, R^{4A}, and R⁵ do not represent a group represented by -L^{a}-R^{a}, R^{a} represent an alkyl group having 5 to 19 carbon atoms, and L^{a} represents a divalent linking group represented by any of the above-described Formulae (L-1) to (L-25) or a divalent linking group formed by two or more divalent linking groups, represented by any of the above-described Formulae (L-1) to (L-25), being bonded to each other.

In Formula (5B), X¹ to X⁴ represent a S atom, R¹, R², R^{3C}, and R^{4B} each independently represent a hydrogen atom or a substituent, R^{b} and R^{c} each independently represent an alkyl group having 5 to 19 carbon atoms, and L^{b} and L^{c} each independently represents a divalent linking group represented by any of the above-described Formulae (L-1) to (L-25) or a divalent linking group formed by two or more divalent linking groups, represented by any of the above-described Formulae (L-1) to (L-25), being bonded to each other.

Examples of the substituents include the above-described substituents W.

### (Compound represented by Formula (6))

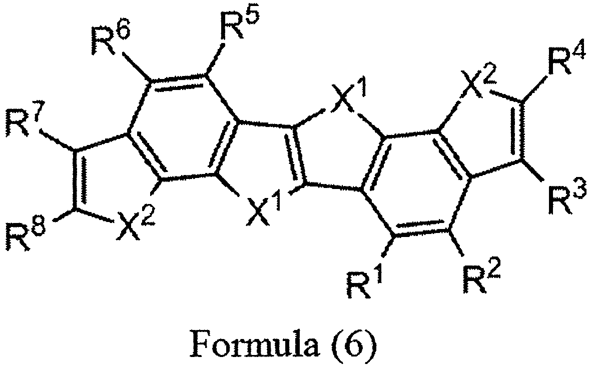

In Formula (6), X¹ and X² represent a S atom.

In Formula (6), R¹ to R⁸ each independently represent a hydrogen atom or a substituent. Further, it is preferable that at least one of R¹, R², ..., or R⁸ represents a substituent represented by Formula (W).

Examples of the substituents represented by R¹ to R⁸ include the substituents W. The definitions of the substituents represented by Fonnula (W) are as described above.

Among R¹ to R⁸ in compounds represented by Formulae (6), the number of substituents represented by Formula (W) is preferably in a range of 1 to 4 from the viewpoints of improving the carrier mobility and the solubility in an organic solvent, more preferably 1 or 2, and particularly preferably 2.

Among R¹ to R⁸, the position of substituents represented by Formula (W) is not particularly limited, but it is preferable that the position thereof is R⁴ or R⁸ from the viewpoints of improving the carrier mobility and the solubility in an organic solvent and more preferable that the positions thereof are R⁴ and R⁸.

Among R¹ to R⁸ in Formula (6), the number of substituents other than the substituents represented by Formula (W) is preferably in a range of 0 to 4, more preferably in a range of 0 to 2, particularly preferably 0 to 1, and more particularly preferably 0.

As a substituent in a case where R¹ to R⁸ represent a substituent other than the substituents represented by Fonnula (W), a group having a linking group chain length of 3.7 Å or less is preferable, a group having a linking group chain length of 1.0 Å to 3.7 Å is more preferable, and a group having a linking group chain length of 1.0 Å to 2.1 Å is still more preferable. The definition of the linking group chain length is as described above.

As a substituent in the case where R¹ to R⁸ each independently represent a substituent other than the substituents represented by Formula (W), a substituted or unsubstituted alkyl group having 2 or less carbon atoms, a substituted alkynyl group having 2 or less carbon atoms, a substituted or unsubstituted alkenyl group having 2 or less carbon atoms, or a substituted or unsubstituted acyl group having 2 or less carbon atoms is preferable, and a substituted or unsubstituted alkyl group having 2 or less carbon atoms is more preferable.

In a case where substituents, represented by R¹ to R⁸, other than the substituents represented by Fonnula (W) each independently represent a substituted alkyl group having 2 or less carbon atoms, examples of the substituent which can be employed by an alkyl group include a cyano group, a fluorine atom, and a deuterium atom. Among these, a cyano group is preferable. As a substituted or unsubstituted alkyl group having 2 or less carbon atoms, which is represented by a substituent in a case where R¹ to R⁸ each independently represent a substituent other than the substituents represented by Formula (W), a methyl group, an ethyl group, or a cyano group-substituted methyl group is preferable, a methyl group or a cyano group-substituted methyl group is more preferable, and a cyano group-substituted methyl group is particularly preferable.

In a case where substituents, represented by R¹ to R⁸, other than the substituents represented by Formula (W) each independently represent a substituted alkynyl group having 2 or less carbon atoms, examples of the substituent which can be employed by an alkynyl group include a deuterium atom. As a substituted or unsubstituted alkynyl group having 2 or less carbon atoms, which is represented by a substituent in a case where R¹ to R⁸ each independently represent a substituent other than the substituents represented by Formula (W), an ethynyl group and a deuterium atom-substituted acetylene group may be exemplified. Among these, an ethynyl group is preferable.

In a case where substituents, represented by R¹ to R⁸, other than the substituents represented by Formula (W) each independently represent a substituted alkenyl group having 2 or less carbon atoms, examples of the substituent which can be employed by an alkenyl group include a deuterium atom. As a substituted or unsubstituted alkenyl group having 2 or less carbon atoms, which is represented by a substituent in a case where R¹ to R⁸ each independently represent a substituent other than the substituents represented by Formula (W), an ethenyl group and a deuterium atom-substituted ethenyl group may be exemplified. Among these, an ethenyl group is preferable.

In a case where substituents, represented by R¹ to R⁸, other than the substituents represented by Formula (W) each independently represent a substituted acyl group having 2 or less carbon atoms, examples of the substituent which can be employed by an acyl group include a fluorine atom. As a substituted or unsubstituted acyl group having 2 or less carbon atoms, which is represented by a substituent in a case where R¹ to R⁸ each independently represent a substituent other than the substituents represented by Formula (W), a formyl group, an acetyl group, or a fluorine-substituted acetyl group may be exemplified. Among these, a formyl group is preferable.

As the compound represented by Formula (6), a compound represented by the following Formula (6A) or (6B) is preferable and a compound represented by Formula (6B) is particularly preferable from the viewpoint of high mobility.

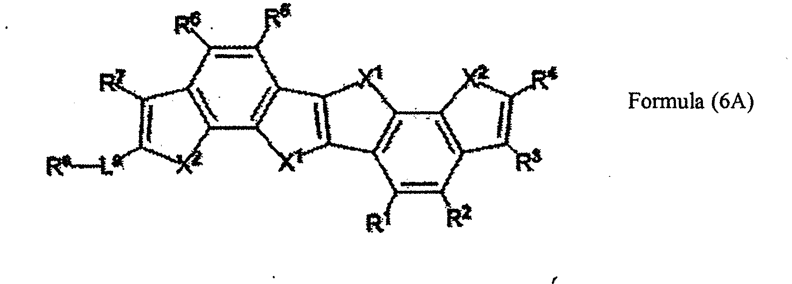

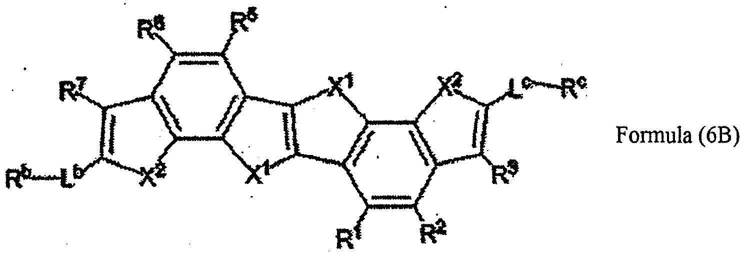

In Formula (6A), X¹ and X² represent a S atom, R¹ to R⁷ each independently represent a hydrogen atom or a substituent. Here, R⁴ does not represent a group represented by -L^{a}-R^{a}, L^{a} represents a divalent linking group represented by any of the above-described Formulae (L-1) to (L-25) or a divalent linking group formed by two or more divalent linking groups, represented by any of the above-described Formulae (L-1) to (L-25), being bonded to each other, and R^{a} represents a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

In Formula (6B), X¹ and X² represent a S atom, R¹ to R³ and R⁵ to R⁷ each independently represent a hydrogen atom or a substituent, L^{b} and L^{c} each independently represent a divalent linking group represented by any of the above-described Formulae (L-1) to (L-25) or a divalent linking group formed by two or more divalent linking groups, represented by any of the above-described Formulae (L-1) to (L-25), being bonded to each other, and R^{b} and R^{c} each independently represent a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

### (Compound represented by Formula (7))

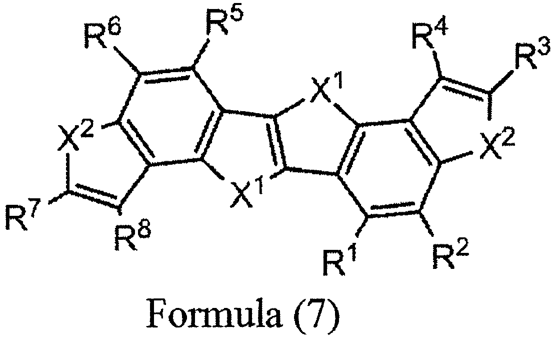

In Formula (7), X¹ and X² represent a S atom.

In Formula (7), R¹ to R⁸ each independently represent a hydrogen atom or a substituent. Further, it is preferable that at least one of R¹, R², ..., or R⁸ represents a substituent represented by Formula (W).

Examples of the substituents represented by R¹ to R⁸ include the substituents W. The definitions of the substituents represented by Formula (W) are as described above.

Among R¹ to R⁸ in compounds represented by Formulae (7), the number of substituents represented by Formula (W) is preferably in a range of 1 to 4 from the viewpoints of improving the carrier mobility and the solubility in an organic solvent, more preferably 1 or 2, and particularly preferably 2.

Among R¹ to R⁸, the position of substituents represented by Formula (W) is not particularly limited, but it is preferable that the position thereof is R³ or R⁷ from the viewpoints of improving the carrier mobility and the solubility in an organic solvent and more preferable that the positions thereof are R³ and R⁷.

Among R¹ to R⁸ in Formula (7), the number of substituents other than the substituents represented by Formula (W) is preferably in a range of 0 to 4, more preferably in a range of 0 to 2, particularly preferably 0 to 1, and more particularly preferably 0.

As a substituent in a case where R¹ to R⁸ represent a substituent other than the substituents represented by Formula (W), a group having a linking group chain length of 3.7 Å or less is preferable, a group having a linking group chain length of 1.0 Å to 3.7 Å is more preferable, and a group having a linking group chain length of 1.0 Å to 2.1 Å is still more preferable. The definition of the linking group chain length is as described above.

As a substituent in the case where R¹ to R⁸ each independently represent a substituent other than the substituents represented by Formula (W), a substituted or unsubstituted alkyl group having 2 or less carbon atoms, a substituted alkynyl group having 2 or less carbon atoms, a substituted or unsubstituted alkenyl group having 2 or less carbon atoms, or a substituted or unsubstituted acyl group having 2 or less carbon atoms is preferable, and a substituted or unsubstituted alkyl group having 2 or less carbon atoms is more preferable.

In a case where substituents, represented by R¹ to R⁸, other than the substituents represented by Formula (W) each independently represent a substituted alkyl group having 2 or less carbon atoms, examples of the substituent which can be employed by an alkyl group include a cyano group, a fluorine atom, and a deuterium atom. Among these, a cyano group is preferable. As a substituted or unsubstituted alkyl group having 2 or less carbon atoms, which is represented by a substituent in a case where R¹ to R⁸ each independently represent a substituent other than the substituents represented by Formula (W), a methyl group, an ethyl group, or a cyano group-substituted methyl group is preferable, a methyl group or a cyano group-substituted methyl group is more preferable, and a cyano group-substituted methyl group is particularly preferable.

In a case where substituents, represented by R¹ to R⁸, other than the substituents represented by Formula (W), each independently represent a substituted alkynyl group having 2 or less carbon atoms, examples of the substituent which can be employed by an alkynyl group include a deuterium atom. As a substituted or unsubstituted alkynyl group having 2 or less carbon atoms, which is represented by a substituent in a case where R¹ to R⁸ each independently represent a substituent other than the substituents represented by Formula (W), an ethynyl group and a deuterium atom-substituted acetylene group may be exemplified. Among these, an ethynyl group is preferable.

In a case where substituents, represented by R¹ to R⁸, other than the substituents represented by Formula (W), each independently represent a substituted alkenyl group having 2 or less carbon atoms, examples of the substituent which can be employed by an alkenyl group include a deuterium atom. As a substituted or unsubstituted alkenyl group having 2 or less carbon atoms, which is represented by a substituent in a case where R¹ to R⁸ each independently represent a substituent other than the substituents represented by Formula (W), an ethenyl group and a deuterium atom-substituted ethenyl group may be exemplified. Among these, an ethenyl group is preferable.

In a case where substituents, represented by R¹ to R⁸, other than the substituents represented by Formula (W), each independently represent a substituted acyl group having 2 or less carbon atoms, examples of the substituent which can be employed by an acyl group include a fluorine atom. As a substituted or unsubstituted acyl group having 2 or less carbon atoms, which is represented by a substituent in a case where R¹ to R⁸ each independently represent a substituent other than the substituents represented by Formula (W), a formyl group, an acetyl group, or a fluorine-substituted acetyl group may be exemplified. Among these, a formyl group is preferable.

As the compound represented by Formula (7), a compound represented by the following Formula (7A) or (7B) is preferable and a compound represented by Formula (7B) is particularly preferable from the viewpoint of high mobility.

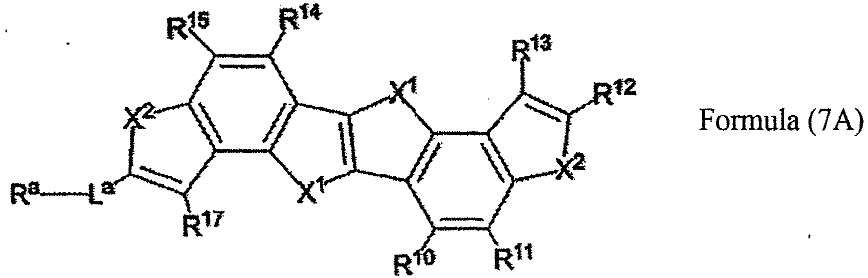

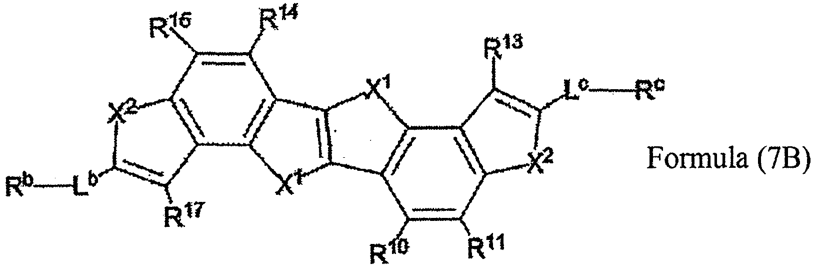

In Formula (7A), X¹ and X² represent a S atom, R¹⁰ to R¹⁵ and R¹⁷ each independently represent a hydrogen atom or a substituent. Here, R¹² does not represent a group represented by -L^{a}-R^{a}, L^{a} represents a divalent linking group represented by any of the above-described Formulae (L-1) to (L-25) or a divalent linking group formed by two or more divalent linking groups, represented by any of the above-described Formulae (L-1) to (L-25), being bonded to each other, and R^{a} represents a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

In Formula (7B), X¹ and X² represent a S atom, R¹⁰ to R¹¹, R¹³ to R¹⁵, and R¹⁷ each independently represent a hydrogen atom or a substituent, L^{b} and L^{c} each independently represent a divalent linking group represented by any of the above-described Formulae (L-1) to (L-25) or a divalent linking group formed by two or more divalent linking groups, represented by any of the above-described Formulae (L-1) to (L-25), being bonded to each other, and R^{b} and R^{c} each independently represent a substituted or unsubstituted alkyl group, a cyano group, a vinyl group, an ethynyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group.

### (Compound represented by Formula (8)) (not forming part of the present invention)

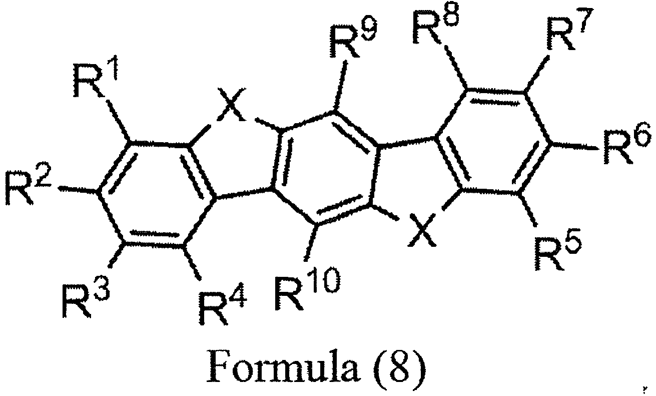

In Formula (8), X represents a S atom.

R³, R⁴, and R⁷ to R¹⁰ each independently represent a hydrogen atom, a halogen atom, or a substituent represented by Formula (W). The definitions of the substituents represented by Formula (W) are as described above. R¹, R², R⁵, and R⁶ each independently represent a hydrogen atom or a substituent. Further, examples of the substituents represented by R¹, R², R⁵, and R⁶ include the substituents W.

Moreover, it is preferable that R³, R⁴, and R⁷ to R¹⁰ each independently represent a hydrogen atom, a halogen atom, or a substituent represented by Formula (W) (here, L is any of (L-3), (L-5), (L-7) to (L-9), and (L-12) to (L-24)). Among these, it is more preferable that R³, R⁴, and R⁷ to R¹⁰ represent a hydrogen atom.

Further, it is preferable that L is any of (L-3), (L-5), (L-13), (L-17), and (L-18).

It is preferable that at least one of R¹, R², ..., or R¹⁰ represents a substituent represented by Formula (W).

Among R¹ to R¹⁰ in compounds represented by Formulae (8), the number of substituents represented by Formula (W) is preferably in a range of 1 to 4 from the viewpoints of improving the carrier mobility and the solubility in an organic solvent, more preferably 1 or 2, and particularly preferably 2.

Among R¹ to R¹⁰, the position of substituents represented by Formula (W) is not particularly limited, but it is preferable that the position thereof is R² or R⁶ from the viewpoints of improving the carrier mobility and the solubility in an organic solvent and more preferable that the positions thereof are R² and R⁶.

Among R¹ to R¹⁰ in Formula (8), the number of substituents other than the substituents represented by Formula (W) is preferably in a range of 0 to 4, more preferably in a range of 0 to 2, particularly preferably 0 to 1, and more particularly preferably 0.

### (Compound represented by Formula (9)) (not forming part of the present invention)

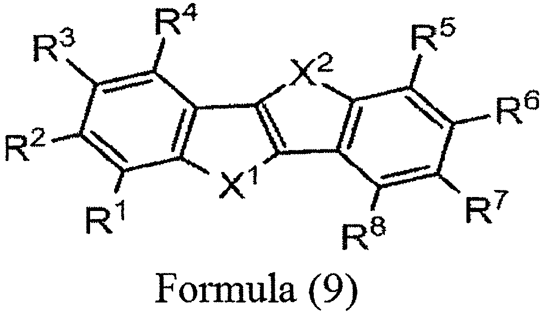

R¹ to R⁸ each independently represent a hydrogen atom or a substituent. Further, it is preferable that at least one of R¹, R², ..., or R⁸ represents a substituent represented by Formula (W). Examples of the substituents represented by R¹ to R⁸ include the substituents W. The definitions of the substituents represented by Formula (W) are as described above.

R¹ to R⁸ each independently represent a halogen atom or a substituent and it is preferable that at least one of R¹, R², ..., or R⁸ represents a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group.

In R¹ to R⁸ of Formula (9), it is preferable that at least one of R² or R⁶ represents a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group; more preferable that at least one of R² or R⁶ represents a substituted or unsubstituted arylthio group or a substituted or unsubstituted heteroarylthio group; still more preferable that both of R² and R⁶ represent a substituted or unsubstituted arylthio group or a heteroarylthio group; particularly preferable that both of R² and R⁶ represent a substituted or unsubstituted phenylthio group or a heteroarylthio group selected from the following group (A); and more particularly preferable that both of R² and R⁶ represent a substituted or unsubstituted phenylthio group or a heteroarylthio group represented by the following Formula (A-17), (A-18), or (A-20).

As the arylthio group, a group formed by a sulfur atom being linked to an aryl group having 6 to 20 carbon atoms is preferable, a naphthylthio group or a phenylthio group is more preferable, and a phenylthio group is particularly preferable.

As the heteroarylthio group, a group formed by a sulfur atom being linked to a 3- to 10-membered ring heteroaryl group is preferable, a group formed by a sulfur atom being linked to a 5- to 6-membered ring heteroaryl group is more preferable, and the following group (A) is particularly preferable.

### Group (A)

| | | | | | |
|---|---|---|---|---|---|
| 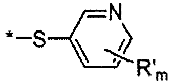 | (A-14) | 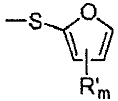 | (A-17) | 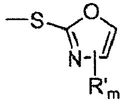 | (A-23) |
| | | 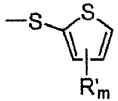 | (A-18) | 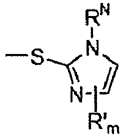 | (A-24) |
| 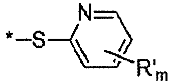 | (A-15) | | | | |
| | | 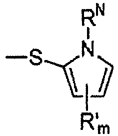 | (A-20) | 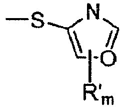 | (A-26) |
| 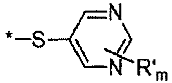 | (A-16) | | | | |
| | | 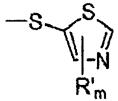 | (A-21) | 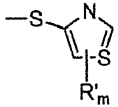 | (A-27) , |

m's in Formulae (A-14) and (A-15) represent 4, m's in Formulae (A-16) to (A-18) and (A-20) represent 3, and m's in Formulae (A-21), (A-23), (A-24), (A-26), and (A-27) represent 2.

In the group (A), R' and R^{N} each independently represent a hydrogen atom or a substituent.

In the group (A), it is preferable that R' represents a hydrogen atom or a substituent represented by Formula (W).

In the group (A), RN represents preferably a substituent, more preferably an alkyl group, an aryl group, or a heteroaryl group, particularly preferably an alkyl group, an aryl group substituted with an alkyl group, or a heteroaryl group substituted with an alkyl group, and more particularly preferably an alkyl group having 1 to 4 carbon atoms, a phenyl group substituted with an alkyl group having 1 to 4 carbon atoms, or a 5-membered heteroaryl group substituted with an alkyl group having 1 to 4 carbon atoms.

As the alkyloxycarbonyl group, a group formed by a carbonyl group being linked to an alkyl group having 1 to 20 carbon atoms is preferable. The number of carbon atoms of the alkyl group is more preferably in a range of 2 to 15 and particularly preferably in a range of 5 to 10.

As the aryloxycarbonyl group, a group formed by a carbonyl group being linked to an aryl group having 6 to 20 carbon atoms is preferable. The number of carbon atoms of the aryl group is more preferably in a range of 6 to 15 and particularly preferably in a range of 8 to 12.

As the alkylamino group, a group formed by an amino group being linked to an alkyl group having 1 to 20 carbon atoms is preferable. The number of carbon atoms is more preferably in a range of 2 to 15 and particularly preferably in a range of 5 to 10.

Among R¹ to R⁸, the number of substituents other than the substituted or unsubstituted arylthio group, the substituted or unsubstituted heteroarylthio group, the substituted or unsubstituted alkyloxycarbonyl group, the substituted or unsubstituted aryloxycarbonyl group, or the substituted or unsubstituted alkylamino group (hereinafter, also referred to as other substituents) is preferably in a range of 0 to 4, more preferably in a range of 0 to 2, particularly preferably 0 or 1, and more particularly preferably 0.

X¹ and X² represent a S atom.

### (Compound represented by Formula (10)) (not forming part of the present invention)

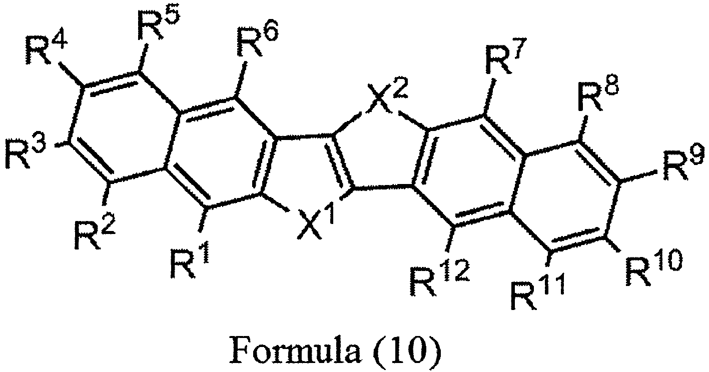

In Formula (10), X¹ and X² represent a S atom, and R¹ to R¹² each independently represent a hydrogen atom or a substituent. Further, it is preferable that at least one of R¹, R², ..., or R¹² represents a substituent represented by Formula (W).

Examples of the substituents include the above-described substituents W. The definitions of the substituents represented by Formula (W) are as described above.

In R¹ to R¹² of Formula (10), it is preferable that at least one of R³ or R⁹ represents a substituted or unsubstituted alkyl group, a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group; more preferable that at least one of R³ or R⁹ represents a substituted or unsubstituted alkyl group; and still more preferable that both of R³ and R⁹ represent a substituted or unsubstituted alkyl group.

### (Compound represented by Formula (11)) (not forming part of the present invention)

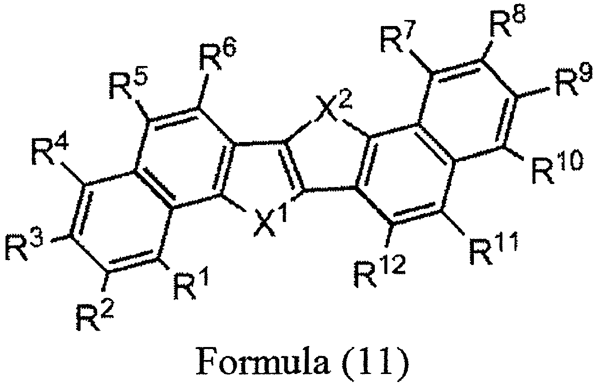

In Formula (11), X¹ and X² represent a S atom, and R¹ to R¹² each independently represent a hydrogen atom or a substituent. Further, it is preferable that at least one of R¹, R², ..., or R¹² represents a substituent represented by Formula (W).

Examples of the substituents include the above-described substituents W. The definitions of the substituents represented by Formula (W) are as described above.

In R¹ to R¹² of Formula (11), it is preferable that at least one of R³ or R⁹ represents a substituted or unsubstituted alkyl group, a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group; more preferable that at least one of R³ or R⁹ represents a substituted or unsubstituted alkyl group; and still more preferable that both of R³ and R⁹ represent a substituted or unsubstituted alkyl group.

### (Compound represented by Formula (12)) (not forming part of the present invention)

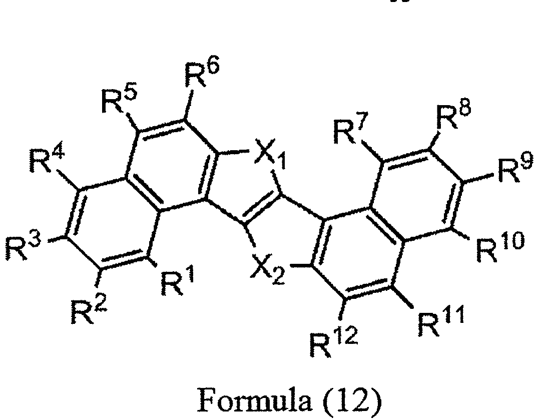

In Formula (12), X¹ and X² represent a S atom, and R¹ to R¹² each independently represent a hydrogen atom or a substituent. Further, it is preferable that at least one of R¹, R², ..., or R¹² represents a substituent represented by Formula (W).

Examples of the substituents include the above-described substituents W. The definitions of the substituents represented by Fonnula (W) are as described above.

In R¹ to R¹² of Fonnula (12), it is preferable that at least one of R³ or R⁹ represents a substituted or unsubstituted alkyl group, a substituted or unsubstituted arylthio group, a substituted or unsubstituted heteroarylthio group, a substituted or unsubstituted alkyloxycarbonyl group, a substituted or unsubstituted aryloxycarbonyl group, or a substituted or unsubstituted alkylamino group; more preferable that at least one of R³ or R⁹ represents a substituted or unsubstituted alkyl group; and still more preferable that both of R³ and R⁹ represent a substituted or unsubstituted alkyl group.

### (Compound represented by Formula (13))

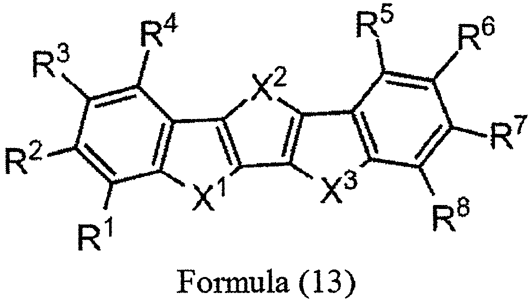

In Formula (13), X¹, X², and X³ represent a S atom, and R¹ to R⁸ each independently represent a hydrogen atom or a substituent. Further, it is preferable that at least one of R¹ to R⁸ represents a substituent represented by Formula (W).

Examples of the substituent include the above-described substituents W. The definitions of the substituents represented by Formula (W) are as described above.

Moreover, in a case where at least one of R¹, R², ..., or R⁸ represents a substituent represented by Formula (W) and R represents an alkyl group, it is preferable that L is any of (L-2) to (L-25).

In the case where R represents an alkyl group, it is preferable that L is any of (L-2) to (L-5), (L-13), (L-17), and (L-18) and more preferable that L is any of (L-3), (L-13), and (L-18).

In R¹ to R⁸ of Formula (13), it is preferable that at least one of R³ or R⁶ represents a substituent represented by Formula (W) and more preferable that both of R³ and R⁶ represent a substituent represented by Formula (W).

### (Compound represented by Formula (14))

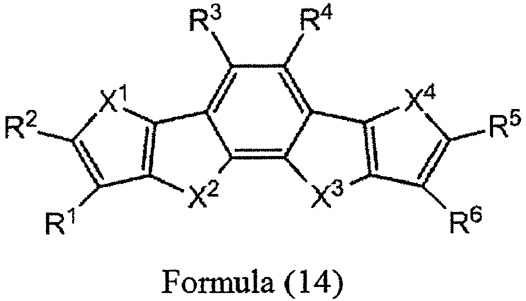

In Formula (14), X¹, X², X³, and X⁴ represent a S atom, and R¹ to R⁶ each independently represent a hydrogen atom or a substituent. Further, it is preferable that at least one of R¹ to R⁶ represents a substituent represented by Formula (W).

Examples of the substituent include the above-described substituents W. The definitions of the substituents represented by Formula (W) are as described above.

In R¹ to R⁶ of Formula (14), it is preferable that at least one of R² or R⁵ represents a substituent represented by Formula (W) and more preferable that both of R² and R⁵ represent a substituent represented by Formula (W).

### (Compound represented by Formula (15))

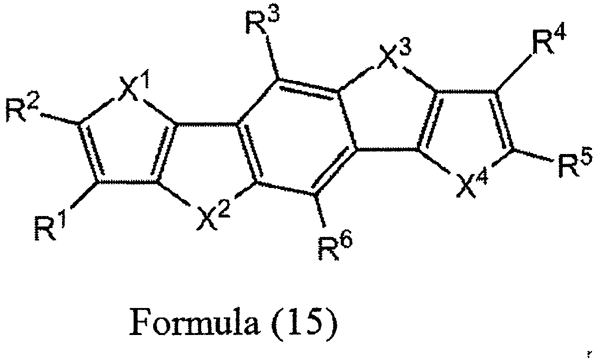

In Formula (15), X¹, X², X³, and X⁴ represent a S atom, and R¹ to R⁶ each independently represent a hydrogen atom or a substituent. Further, it is preferable that at least one of R¹ to R⁶ represents a substituent represented by Formula (W).

Examples of the substituent include the above-described substituents W. The definitions of the substituents represented by Formula (W) are as described above.

Moreover, it is preferable that R³ and R⁶ represent a hydrogen atom, a halogen atom, or a substituent represented by Formula (W) (here, L is any of (L-3), (L-5), (L-7) to (L-9), and (L-12) to (L-24)). It is preferable that R¹, R², R⁴, R⁵, and R¹³ each independently represent a hydrogen atom or a substituent.

Further, it is preferable that L is any of (L-3), (L-5), (L-7) to (L-9), and (L-12) to (L-24). In a case where R³ and R⁶ represent a substituent represented by Formula (W), it is preferable that L is any of (L-3), (L-5), (L-13), (L-17), and (L-18).

In R¹ to R⁶ of Formula (15), it is preferable that at least one of R¹ or R⁴ represents a substituent represented by Formula (W) and more preferable that both of R¹ and R⁴ represent a substituent represented by Formula (W).

Further, it is preferable that R³ and R⁶ represent a hydrogen atom.

The molecular weight of the above-described first organic semiconductor compound and second organic semiconductor compound (compounds represented by Formula (1) to (15)) is not particularly limited, but is preferably 3000 or less, more preferably 2000 or less, still more preferably 1000 or less, and particularly preferably 850 or less. From the viewpoint that the solubility in a solvent can be increased, it is preferable that the molecular weight thereof is set to be less than or equal to the above-described upper limits.

Meanwhile, from the viewpoint of film quality stability of a thin film, the molecular weight thereof is preferably 300 or greater, more preferably 350 or greater, and still more preferably 400 or greater.

A method of synthesizing the above-described first organic semiconductor compound and second organic semiconductor compound (compounds represented by Formulae (1) to (15)) is not particularly limited, and the compounds can be synthesized by referring to known methods. Examples of the references related to the known methods include Journal of American Chemical Society, 116, 925 (1994), Journal of Chemical Society, 221 (1951), Org. Lett., 2001, 3, 3471, Macromolecules, 2010, 43, 6264, Tetrahedron, 2002, 58, 10197, JP2012-513459A, JP2011-46687A, Journal of Chemical Research. Miniprint, 3, 601 to 635 (1991), Bull. Chem. Soc. Japan, 64, 3682 to 3686 (1991), Tetrahedron Letters, 45, 2801 to 2803 (2004), EP2251342A1, EP2301926A1, EP2301921A1, KR10-2012-0120886A, J. Org. Chem. 2011, 696, Org. Lett., 2001, 3, 3471, Macromolecules 2010, 43, 6264, J. Org. Chem. 2013, 78, 7741, Chem. Eur. J. 2013, 19, 3721, Bull. Chem. Soc. Jpn., 1987, 60, 4187, J. Am. Chem. Soc. 2011, 133, 5024, Chem. Eur. J. 2013, 19, 3721, Macromolecules, 2010, 43, 6264 to 6267, and J. Am. Chem. Soc. 2012, 134, 16548 to 16550.

Moreover, from the viewpoint of obtaining more excellent effects of the present invention, it is preferable that the first organic semiconductor compound and the second organic semiconductor compound include at least one selected from the group consisting of compounds represented by Formulae (5) and (13) to (15).

### <Organic solvent>

An organic solvent is not particularly limited as long as the solvent is allowed to dissolve the above-described first organic semiconductor compound and second organic semiconductor compound, and known organic solvents can be used.

Examples of the organic solvent include a hydrocarbon-based solvent such as hexane, octane, decane, toluene, xylene, mesitylene, ethylbenzene, decalin, or 1-methylnaphthalene; a ketone-based solvent such as acetone, methyl ethyl ketone, methyl isobutyl ketone, or cyclohexanone; a halogenated hydrocarbon-based solvent such as dichloromethane, chloroform, tetrachloromethane, dichloroethane, trichloroethane, tetrachloroethane, chlorobenzene, dichlorobenzene, or chlorotoluene; an ester-based solvent such as ethyl acetate, butyl acetate, or amyl acetate; an alcohol-based solvent such as methanol, propanol, butanol, pentanol, hexanol, cyclohexanol, methyl cellosolve, ethyl cellosolve, or ethylene glycol; an ether-based solvent such as dibutyl ether, tetrahydrofuran, dioxane, or anisole; an amide or imide-based solvent such as N,N-dimethylformamide, N,N-dimethylacetamide, 1-methyl-2-pyrrolidone, or 1-methyl-2-imidazolidinone; a sulfoxide-based solvent such as dimethyl sulfoxide; and a nitrile-based solvent such as acetonitrile.

Among these, from the viewpoint of obtaining more excellent effects of the present invention, a hydrocarbon-based solvent, a halogenated hydrocarbon-based solvent, or an ether-based solvent is preferable, toluene, xylene, methylene, tetralin, dichlorobenzene, or anisole is more preferable, and toluene, xylene, tetralin, or anisole is particularly preferable.

### (Other components)

The composition of the present invention may include the first organic semiconductor compound, the second semiconductor compound, and other components other than the organic solvent.

For example, the composition may include a polymer compound. The polymer compound is not particularly limited, and known polymer compounds may be exemplified. As a preferred embodiment of the polymer compound, a polymer compound (a polymer which includes a repeating unit having a benzene ring group) having a benzene ring is preferable. The content of the repeating unit having a benzene ring group is not particularly limited, but is preferably 50% by mole or greater, more preferably 70% by mole or greater, and still more preferably 90% by mole or greater with respect to the total content of all repeating units. The upper limit thereof is not particularly limited, and 100% by mole may be exemplified.

Examples of the polymer compound include polystyrene, poly(α-methylstyrene), polyvinyl cinnamate, poly(4-vinylphenyl), and poly(4-methylstyrene).

Further, the weight-average molecular weight of the polymer compound is not particularly limited, but is preferably in a range of 10000 to 2000000 and more preferably in a range of 20000 to 600000.

### <Composition>

The composition includes at least the first organic semiconductor compound, the second organic semiconductor compound, and an organic solvent.

The content of the first organic semiconductor compound and the second organic semiconductor compound in the composition is not particularly limited, but is preferably in a range of 0.4% to 10.0% by mass, more preferably in a range of 0.6% to 8.0% by mass, and still more preferably in a range of 0.8% to 5.0% by mass with respect to the total mass of the composition, from the viewpoint of obtaining more excellent effects of the present invention.

The ratio (mass of first organic semiconductor compound/mass of second organic semiconductor compound) of the mass of the first organic semiconductor compound to the mass of the second organic semiconductor compound in the composition is in a range of 0.3 to 3.0, and preferably in a range of 0.5 to 2.0, from the viewpoint of obtaining more excellent effects of the present invention.

The saturated solubility of a mixture between the first organic semiconductor compound and the second organic semiconductor compound in the organic solvent is not particularly limited, but is preferably 0.4% by mass or greater and more preferably 0.6% by mass or greater. The upper limit thereof is not particularly limited, but is preferably 5% by mass or less from the viewpoint of handleability.

The content of the organic solvent in the composition is not particularly limited, but is preferably 90% to 99.6% by mass and more preferably in a range of 95% to 99.0% by mass with respect to the total mass of the composition, from the viewpoint of obtaining more excellent effects of the present invention.

In a case where the composition includes a polymer compound, from the viewpoint of obtaining more excellent effects of the present invention, the content of the polymer compound is preferably in a range of 0.4% to 8.0% by mass, more preferably in a range of 0.7% to 5.0% by mass, still more preferably in a range of 1.0% to 4.0% by mass, and particularly preferably in a range of 1.5% to 3.0% by mass with respect to the total mass of the composition.

The viscosity of the composition is not particularly limited, but is preferably in a range of 3 to 100 mPa·s, more preferably in a range of 5 to 50 mPa·s, and still more preferably in a range of 9 to 40 mPa·s, from the viewpoints of obtaining more excellent effects of the present invention and more excellent coating properties.

Moreover, the viscosity here indicates a viscosity at a temperature of 25°C.

A method of producing the composition is not particularly limited, and known methods can be employed. For example, a desired composition can be obtained by adding a predetermined amount of first organic semiconductor compound and second organic semiconductor compound to an organic solvent and appropriately performing a stirring treatment thereon.

### <Organic semiconductor film and organic transistor>

The composition of the present invention can be suitably used for an application for forming an organic semiconductor film.

A method of producing an organic semiconductor film using the composition is not particularly limited, and known methods can be employed. A method of applying the composition to a predetermined base material and performing a drying treatment, if necessary, to produce an organic semiconductor film may be exemplified.

The method of applying the composition to a base material is not particularly limited, and known methods can be employed. Examples of the known methods include an ink-jet printing method, a flexographic printing method, a bar coating method, a spin coating method, a knife coating method, and a doctor blade method. Among these, an ink-jet printing method and a flexographic printing method are preferable.

Further, as a preferred embodiment of the flexographic printing method, a method of using a photosensitive resin plate as a flexographic printing plate may be exemplified. According to the embodiment, the composition is printed on the substrate and thus a pattern can be easily formed.

The drying treatment is a treatment that is performed when necessary and appropriate optimal conditions are selected according to the kind of organic semiconductor compound or organic solvent to be used. From the viewpoints of obtaining more excellent effects of the present invention and excellent productivity, the heating temperature is preferably in a range of 30°C to 100°C and more preferably in a range of 40°C to 80°C; and the heating time is preferably in a range of 10 to 300 minutes and more preferably in a range of 30 to 180 minutes.

The film thickness of the organic semiconductor film to be formed is not particularly limited, but is preferably in a range of 10 to 500 nm and more preferably in a range of 30 to 200 nm, from the viewpoint of obtaining more excellent effects of the present invention.

The organic semiconductor film to be produced using the above-described composition shows excellent mobility and has a small variation in mobility between samples (that is, a variation in mobility between lots is small).

The above-described organic semiconductor film can be suitably used for an organic transistor (organic thin-film transistor).

An embodiment of an organic thin-film transistor of the present invention will be described with reference to the accompanying drawings.

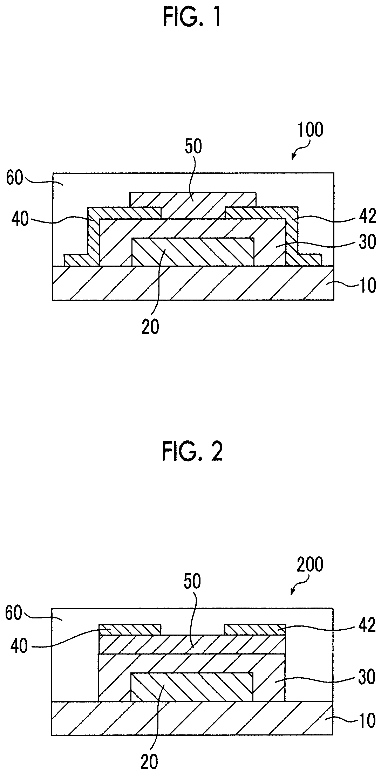

Fig. 1 is a view schematically illustrating a section of an organic thin-film transistor according to an embodiment of the present invention.

In Fig. 1, an organic thin-film transistor 100 includes a substrate 10, a gate electrode 20 disposed on the substrate 10, a gate insulating film 30 that covers the gate electrode 20, a source electrode 40 and a drain electrode 42 that are in contact with the surface on the opposite side to the gate electrode 20 side of the gate insulating film 30, an organic semiconductor film 50 that covers the surface of the gate insulating film 30 between the source electrode 40 and the drain electrode 42, and a sealing layer 60 that covers each of the members. The organic thin-film transistor 100 is a bottom-gate bottom-contact type organic thin-film transistor.

Further, in Fig. 1, the organic semiconductor film 50 corresponds to a film formed of the above-described composition.

Hereinafter, the substrate, the gate electrode, the gate insulating film, the source electrode, the drain electrode, the organic semiconductor film, and the sealing layer and methods of forming each member will be described in detail.

### <Substrate>

A substrate plays a role of supporting a gate electrode, a source electrode, or a drain electrode described below.

The substrate is not particularly limited, and examples thereof include a plastic substrate, a glass substrate, and a ceramic substrate. Among these, from the viewpoint of applicability to each device and the cost, a glass substrate or a plastic substrate is preferable.

Examples of the material of the plastic substrate include a thermosetting resin (such as an epoxy resin, a phenolic resin, a polyimide resin, or a polyester resin (for example, PET or PEN)) and a thermoplastic resin (such as a phenoxy resin, polyether sulfone, polysulfone, or polyphenylene sulfone).

Examples of the material of the ceramic substrate include alumina, aluminum nitride, zirconia, silicon, silicon nitride, and silicon carbide.

Examples of the material of the glass substrate include soda glass, potash glass, borosilicate glass, quartz glass, aluminosilicate glass, and lead glass.

### <Gate electrode, source electrode, and drain electrode>

Examples of materials of the gate electrode, the source electrode, and the drain electrode include metals such as gold (Au), silver, aluminum (Al), copper, chromium, nickel, cobalt, titanium, platinum, tantalum, magnesium, calcium, barium, and sodium; conductive oxides such as InO₂, SnO₂, and ITO; conductive polymers such as polyaniline, polypyrrole, polythiophene, polyacetylene, and polydiacetylene; semiconductors such as silicon, germanium, and gallium arsenide; and carbon materials such as fullerene, carbon nanotube, and graphite. Among these, metals are preferable and silver and aluminum are more preferable.

The thickness of the gate electrode, the source electrode, or the drain electrode is not particularly limited, but is preferably in a range of 20 to 200 nm.

The methods of forming the gate electrode, the source electrode, and the drain electrode are not particularly limited, and examples thereof include a method of vacuum-vapor depositing or sputtering an electrode material on a substrate and a method of applying or printing an electrode-forming composition. Further, in a case where an electrode is patterned, examples of the patterning method include a photolithography method; a printing method such as an ink-jet printing method, a screen printing method, an offset printing method, or a letterpress printing method; and a mask vapor deposition method.

### <Gate insulating film>

Examples of the material of the gate insulating film include polymers such as polymethyl methacrylate, polystyrene, polyvinyl phenol, polyimide, polycarbonate, polyester, polyvinyl alcohol, polyvinyl acetate, polyurethane, polysulfone, polybenzoxazole, polysilsesquioxane, an epoxy resin, and a phenolic resin; oxides such as silicon dioxide, aluminum oxide, and titanium oxide; and nitrides such as silicon nitride. Among these materials, from the viewpoint of compatibility with the organic semiconductor film, polymers are preferable.

In a case of using a polymer as a material of the gate insulating film, it is preferable to use a crosslinking agent (for example, melamine) in combination with the polymer. When a crosslinking agent is used in combination, the polymer is cross-linked so that the durability of a gate insulating film to be formed is improved.

The film thickness of the gate insulating film is not particularly limited, but is preferably in a range of 100 to 1000 nm.

The method of forming a gate insulating film is not particularly limited, and examples thereof include a method of coating a substrate, on which a gate electrode is formed, with a gate insulating film forming composition; and a method of performing vapor deposition or sputtering on a gate insulating film material. The method of coating a substrate with a gate insulating film forming composition is not particularly limited, and a known method (a bar coating method, a spin coating method, a knife coating method, or a doctor blade method) can be used.

In a case where a gate insulating film is formed by coating a substrate with a gate insulating film forming composition, the composition may be heated (baked) after the application for the purpose of crosslinking or removing a solvent.

### <Organic semiconductor film>

An organic semiconductor film is a film formed of the above-described composition.

The method of forming an organic semiconductor film is not particularly limited, and a desired organic semiconductor film can be formed by applying the above-described composition to a source electrode, a drain electrode, and a gate insulating film and performing a drying treatment thereon as needed.

### <Sealing layer>

From the viewpoint of durability, it is preferable that the organic thin-film transistor of the present invention includes a sealing layer as an outermost layer. A known sealant can be sued for a sealing layer.

The thickness of the sealing layer is not particularly limited, but is preferably in a range of 0.2 to 10 µm.

The method of forming a sealing layer is not particularly limited, and a method of coating a substrate, on which a gate electrode, a gate insulating film, a source electrode, a drain electrode, and an organic semiconductor film are formed, with a sealing layer forming composition may be exemplified. Specific examples of applying the sealing layer forming composition are the same as the examples of applying the gate insulating film forming composition. In a case where an organic semiconductor film is formed by coating a substrate with a sealing layer forming composition, the composition may be heated (baked) after the application for the purpose of crosslinking or removing a solvent.

Fig. 2 is a view schematically illustrating a section of an organic thin-film transistor according to another embodiment of the present invention.

In Fig. 2, an organic thin-film transistor 200 includes a substrate 10, a gate electrode 20 disposed on the substrate 10, a gate insulating film 30 that covers the gate electrode 20, an organic semiconductor film 50 disposed on the gate insulating film 30, a source electrode 40 and a drain electrode 42 that are disposed on the organic semiconductor film 50, and a sealing layer 60 that covers each of the members. Here, the source electrode 40 and the drain electrode 42 are formed using the above-described composition of the present invention. The organic thin-film transistor 200 is a top-contact type organic thin-film transistor.

The descriptions on the substrate, the gate electrode, the gate insulating film, the source electrode, the drain electrode, the organic semiconductor film, and the sealing layer are as described above.

Hereinbefore, the embodiments of the bottom-gate bottom-contact type organic thin-film transistor and the bottom-gate top-contact type organic thin-film transistor have been described with reference to Figs. 1 and 2, but the composition of the present invention can be applied to a top-gate bottom-contact type organic thin-film transistor and a top-gate top-contact type organic thin-film transistor.

Further, the above-described organic thin-film transistor can be suitably used for electronic paper or display devices.

### Examples

Hereinafter, examples will be described, but the present invention is not limited thereto.

### (Examples and comparative examples: preparation of composition)

A mixed solution (total amount of 20 g) including an organic semiconductor compound at a predetermined ratio (% by mass with respect to total mass of composition) listed in Table 1 (Part 1), anisole as an organic solvent, and poly(α-methylstyrene) (molecular weight: 400000, manufactured by manufactured by Sigma-Aldrich Co., LLC.) (0.3 g) as a polymer compound was weighed in a 50 ml glass vial and mixed using a mix rotor (manufactured by AS ONE Corporation) for 10 minutes. The solution was filtered through a membrane filter having a pore diameter of 0.5 µm, thereby obtaining a composition.

### (Examples and comparative examples: production of organic transistor)

A bottom-gate bottom-contact type organic transistor was formed in the following manner.

### (Formation of gate electrode)

A wiring pattern having a width of 100 µm and a film thickness of 100 nm was formed on a non-alkali glass substrate (5 cm × 5 cm) by ink-jet printing silver nano-ink (H-1, manufactured by Mitsubishi Materials Corporation) using DMP2831 (1 picoliter head). Thereafter, the formed pattern was baked on a hot plate at 200°C for 90 minutes in air, thereby forming a gate electrode wiring.

### (Formation of gate insulating film)

5 parts by mass of polyvinyl phenol (Mw: 25000, manufactured by Sigma-Aldrich Co., LLC.), 5 parts by mass of melamine, and 90 parts by mass of polyethylene glycol monomethyl ether acetate were stirred and mixed with each other and filtered through a membrane filter having a pore diameter of 0.2 µm, thereby preparing a solution. The obtained solution was added dropwise to a glass substrate on which a gate electrode was prepared, and the substrate was coated with the solution according to a spin coating method (1000 rpm for 120 seconds) and heated at 150°C for 30 minutes, thereby forming a gate insulating film.

### (Formation of source electrode and drain electrode)

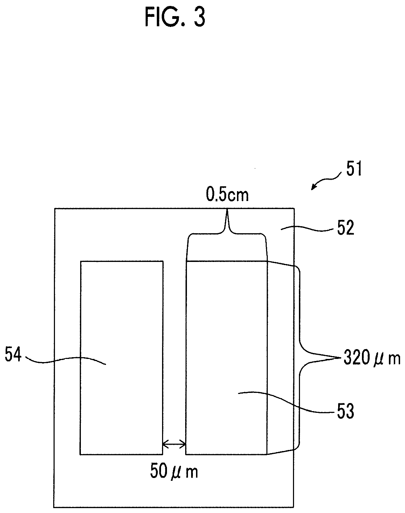

A metal mask having a plurality of patterns illustrated in Fig. 3 was placed on the center of the substrate coated with the insulating film, and the substrate was irradiated with UV ozone for 30 minutes, and then a mask opening portion was reformed on the surface to which a hydrophilic treatment was applied. Further, in Fig. 3, a metal mask 51 includes a mask portion 52 that shields light; and opening portions 53 and 54. Ink-jet printing was performed on the periphery of the reformed portion using DMP2831 (1 picoliter head), thereby forming a source electrode and drain electrode pattern having a channel length of 50 µm and a channel width of 320 µm. The obtained substrate was baked on a hot plate at 200°C for 90 minutes in a N₂ atmosphere (environment in glove box with oxygen concentration of 20 ppm or less), and then a source electrode and a drain electrode having a film thickness of 200 nm were formed.

### (Organic semiconductor film: flexographic printing method)

The substrate on which the source electrode and the drain electrode were formed was coated with the composition (composition in Table 1) prepared in the above according to a flexographic printing method. A flexographic aptitude testing machine F1 (manufactured by IGT Testing Systems K.K.) was used as a printing device and a 1.70% AFP DSH plate (manufactured by Asahi Kasei Corporation) with a solid image was used as a flexographic resin plate. After printing was performed at a pressure, between the plate and the substrate, of 60 N and a conveyance speed of 0.4 m/sec, and an organic semiconductor film (film thickness: 50 nm) was prepared between the source electrode and the drain electrode by performing drying in a temperature range of room temperature to 40°C for 2 hours, thereby producing an organic transistor.

The organic transistor (organic transistor element) produced in the above-described manner was evaluated as follows.

### (Measurement of mobility)

Five organic transistors were produced in the above-described manner, and then the carrier mobilities thereof were respectively measured using a semiconductor characteristic evaluation device B2900A (manufactured by Agilent Technologies). The obtained five mobilities were arithmetically averaged and scored on 1 to 5 scales according to the values of the obtained mobilities.
5: 0.2 cm²/Vs or greater
4: 0.1 cm²/Vs or greater and less than 0.2 cm²/Vs
3: 0.02 cm²/Vs or greater and less than 0.1 cm²/Vs
2: 0.002 cm²/Vs or greater and less than 0.02 cm²/Vs
1: less than 0.002 cm²/Vs

### (Variation in mobility)

Five organic transistors were produced in the above-described manner, the mobilities were respectively evaluated, and then a variation σ with respect to the average value was evaluated. According to the method of measuring the variation σ, first, the mobilities of the five organic transistors were acquired, these mobilities were arithmetically averaged to acquire an average value X, "differences" between the average value X and mobility values of respective samples, an average value Y of these "differences" was calculated, and the variation σ was acquired using "(average value Y/average value X) × 100".
5: The variation was less than 20%
4: The variation was 20% or greater and less than 30%
3: The variation was 30% or greater and less than 50%
2: The variation was 50% or greater and less than 100%
1: The variation was 100% or greater

In Table 1 Examples 1 to 3, 6, 12 and 13 are comparative examples.

**Table 1 (Part 1)**

| | Composition | | | | | | Evaluation | |
|---|---|---|---|---|---|---|---|---|
| | First organic semiconductor compound | Second organic semiconductor compound | Other organic semiconductor compounds | Concentration of first organic semiconductor compound | Concentration of second organic semiconductor compound | Concentration of other organic semiconductor compounds | Mobility | Variation in mobility |
| Example 1 | 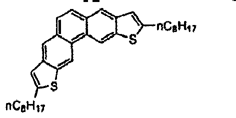 | 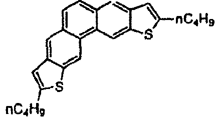 | | 0.4 wt% | 0.4 wt% | | 4 | 3 |
| Example 2 | 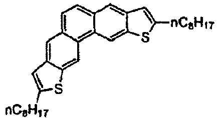 | 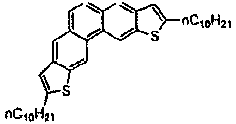 | | 0.4 wt% | 0.4 wt% | | 4 | 4 |
| Example 3 | 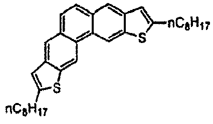 | 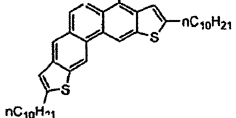 | 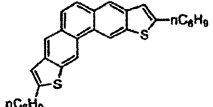 | 0.4 wt% | 0.4 wt% | 0.4 wt% | 4 | 4 |
| Example 5 | 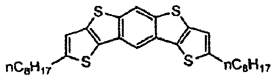 | 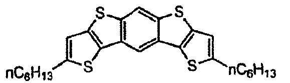 | | 0.4 wt% | 0.4 wt% | | 4 | 5 |
| Example 6 | 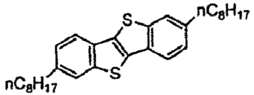 | 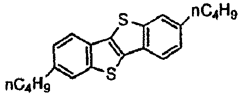 | | 0.4 wt% | 0.4 wt% | | 3 | 3 |

**Table 1 (Part 2)**

| | Composition | | | | | | Evaluation | |
|---|---|---|---|---|---|---|---|---|
| | First organic semiconductor compound | Second organic semiconductor compound | Other organic semiconductor compounds | Concentration of first organic semiconductor compound | Concentration of second organic semiconductor compound | Concentration of other organic semiconductor compounds | Mobility | Variation in mobility |
| Example 7 | 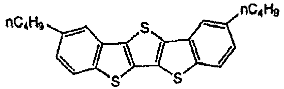 | 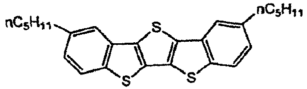 | | 0.4 wt% | 0.4 wt% | | 5 | 5 |
| Example 8 | 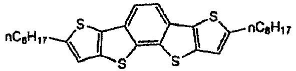 | 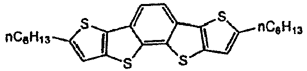 | | 0.3 wt% | 0.3 wt% | | 4 | 5 |
| Example 9 | 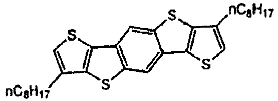 | 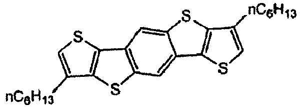 | | 0.3 wt% | 0.3 wt% | | 4 | 5 |
| Example 10 | 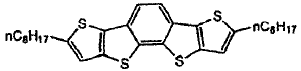 | 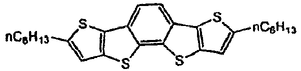 | | 0.27 wt% | 0.54 wt% | | 4 | 5 |
| Example 11 | 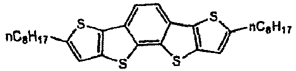 | 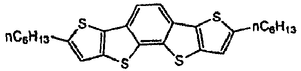 | | 0.2 wt% | 0.4 wt% | | 4 | 4 |
| Example 12 | 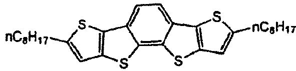 | 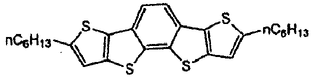 | | 0.05 wt% | 0.4 wt% | | 3 | 4 |

**Table 1 (Part 3)**

| | Composition | Evaluation | | | | | | |
|---|---|---|---|---|---|---|---|---|
| | First organic semiconductor compound | Second organic semiconductor compound | Other organic semiconductor compounds | Concentration of first organic semiconductor compound | Concentration of second organic semiconductor compound | Concentration of other organic semiconductor compounds | Mobility | Variation in mobility |
| Example 13 | 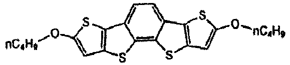 | 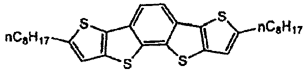 | | 0.05 wt% | 0.4 wt% | | 3 | 3 |
| Example 14 | 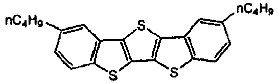 | 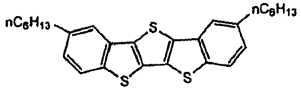 | | 0.4 wt% | 0.4 wt% | | 4 | 5 |
| Example 15 | 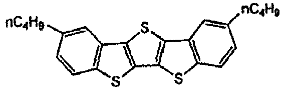 | 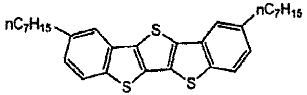 | | 0.4 wt% | 0.4 wt% | | 4 | 4 |
| Example 16 | 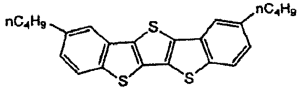 | 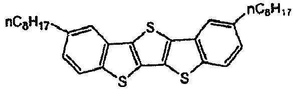 | | 0.4 wt% | 0.4 wt% | | 3 | 4 |
| Example 17 | 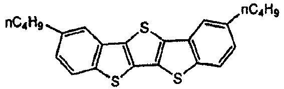 | 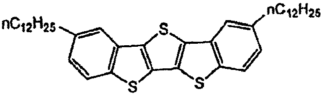 | | 0.4 wt% | 0.4 wt% | | 3 | 3 |
| Example 18 | 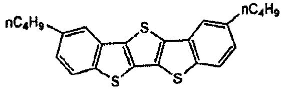 | 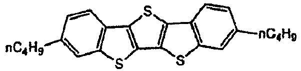 | | 0.4 wt% | 0.4 wt% | | 4 | 5 |

**Table 1 (Part 4)**

| | Composition | | | | | | Evaluation | |
|---|---|---|---|---|---|---|---|---|
| | First organic semiconductor compound | Second organic semiconductor compound | Other organic semiconductor compounds | Concentration of first organic semiconductor compound | Concentration of second organic semiconductor compound | Concentration of other organic semiconductor compounds | Mobility | Variation in mobility |
| Comparative Example 1 | 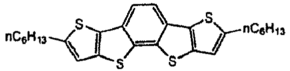 | | | 0.4 wt% | | | 3 | 2 |
| Comparative Example 2 | 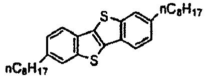 | | | 0.4 wt% | | | 2 | 2 |
| Comparative Example 3 | 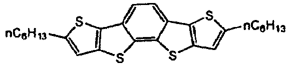 | | | 0.4 wt% | | | Impossible to form uniform film | |
| Comparative Example 4 Comparative | 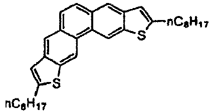 | 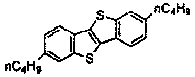 | | 0.4 wt% | 0.4 wt% | | 2 | 1 |

The organic semiconductor compounds used in the above-described examples and comparative examples were synthesized by referring to references (J. Org. Chem. 2011, 696, Org. Lett. 2001, 3, 3471, Macromolecules 2010, 43, 6264, J. Org. Chem. 2013, 78, 7741, Chem. Eur. J. 2013, 19, 3721, Chem. Commun. 2008, 1548 to 1550, Org. Lett. 2007, 9, 4499, Journal of Scientific and Industrial Research, 1958, vol. 17 B, p. 260 to 265, Journal of Scientific and Industrial Research, 1955, vol. 14 B, p. 11, J. Am. Chem. Soc. 2012, 134, 16548 to 16550, WO2005-087780A, JP2009-190999A, and JP2012-206953A).

As listed in the above-described tables, an organic semiconductor film having desired effects was produced using the composition of the present invention.

As understood from the comparison of Examples 1 to 9, it was confirmed that the embodiment in which the mother nucleus had three or four thiophene rings exhibited more excellent effects. Further, it was confirmed that the effects were most excellent in the case where the mother nucleus had three thiophene rings.

Further, as understood from the comparison of Examples 8 and 10 to 12, it was confirmed that the more excellent effects were obtained in the case where the ratio (mass of first organic semiconductor compound/mass of second organic semiconductor compound) of the mass of the first organic semiconductor compound to the mass of the second semiconductor compound was in a range of 0.3 to 3.0.

Further, from the comparison of Examples 12 and 13, it was confirmed that the more excellent effects were obtained in the case where the substituent X and the substituent Y were both alkyl groups.

Further, from the comparison of Example 7 and Examples 14 to 17, it was confirmed that the more excellent effects were obtained in the case where a difference in the number of carbon atoms between the substituent X and the substituent Y was 4 or less.

Meanwhile, in Comparative Examples 1 and 2 in which only one kind of organic semiconductor compound was used and Comparative Example 4 in which two kinds of organic semiconductor compound having mother nuclei different from each other, desired effects were not obtained.

Further, in Comparative Example 3 in which only one kind of organic semiconductor compound was used, it was not possible to prepare a uniform film. Therefore, various evaluations were not able to be performed.

### Explanation of References

- 10:: substrate
- 20:: gate electrode
- 30:: gate insulating film
- 40:: source electrode
- 42:: source electrode
- 50:: organic semiconductor film
- 51:: metal mask
- 52:: mask portion
- 53, 54:: opening portion
- 60:: sealing layer
- 100, 200:: organic thin-film transistor

## Claims

1. An organic semiconductor film forming composition comprising at least: a first organic semiconductor compound which includes a mother nucleus that has two or more thiophene rings and is formed of a fused ring structure having at least four or more rings including the thiophene rings, and a substituent X bonded to the mother nucleus in a molecule;
a second organic semiconductor compound which includes the same mother nucleus as the mother nucleus of the first organic semiconductor compound and satisfies any one requirement selected from the group consisting of the following requirements 1 to 3; and
an organic solvent,
Requirement 1: The second organic semiconductor compound includes a substituent Y which is bonded to the mother nucleus in the second organic semiconductor compound and different from the substituent X in the first organic semiconductor compound,
Requirement 2: The second organic semiconductor compound includes the substituent X bonded to the mother nucleus, and a binding position of the substituent X with respect to the mother nucleus in the first organic semiconductor compound is different from a binding position of the substituent X with respect to the mother nucleus in the second organic semiconductor compound, and
Requirement 3: The second organic semiconductor compound does not include a substituent,
wherein the mother nucleus includes at least three or more thiophene rings,
wherein the substituent X and the substituent Y are substituents each including an alkyl group having 1 to 16 carbon atoms, and
**characterized in that** a ratio of the mass of the first organic semiconductor compound to the mass of the second organic semiconductor compound is in a range of 0.3 to 3.0, and
the ratio indicates the mass of the first organic semiconductor compound to the mass of
the second organic semiconductor compound in the film forming composition.

2. The organic semiconductor film forming composition according to claim 1, wherein the mother nucleus includes three or four thiophene rings.

3. The organic semiconductor film forming composition according to claim 1 or 2, wherein the mother nucleus includes three thiophene rings.

4. The organic semiconductor film forming composition according to any one of claims 1 to 3, wherein the number of rings in the mother nucleus is five.

5. The organic semiconductor film forming composition according to any one of claims 1 to 4, wherein the alkyl group is a linear alkyl group.

6. The organic semiconductor film forming composition according to any one of claims 1 to 5, wherein the second organic semiconductor compound satisfies the requirement 1 or the requirement 2,
the first organic semiconductor compound includes two substituents X and the second organic semiconductor compound includes two substituents Y in a case where the requirement 1 is satisfied, and
the first organic semiconductor compound includes two substituents X and the second organic
semiconductor compound includes two substituents X in a case where the requirement 2 is satisfied.

7. The organic semiconductor film forming composition according to any one of claims 1 to 5, wherein the second organic semiconductor compound satisfies the requirement 1, and the binding position of the substituent X with respect to the mother nucleus in the first organic semiconductor compound is the same as a binding position of the substituent Y with respect to the mother nucleus in the second organic semiconductor compound.

8. The organic semiconductor film forming composition according to any one of claims 1 to 7, wherein the second organic semiconductor compound satisfies the requirement 1, and
a difference in the number of carbon atoms between the substituent X and the substituent Y is 4 or less.

9. The organic semiconductor film forming composition according to any one of claims 1 to 8, wherein the second organic semiconductor compound satisfies the requirement 1, and the substituent X and the substituent Y are linear alkyl groups each having 1 to 16 carbon atoms.

10. The organic semiconductor film forming composition according to any one of claims 1 to 9, wherein the total amount of the first organic semiconductor compound and the second organic semiconductor compound is in a range of 0.4 % to 10.0 % by mass with respect to the total mass of the composition.

11. The organic semiconductor film forming composition according to any one of claims 1 to 10, wherein the total amount of the first organic semiconductor compound and the second organic semiconductor compound is in a range of 0.6 % to 8.0 % by mass with respect to the total mass of the composition.

12. The organic semiconductor film forming composition according to any one of claims 1 to 11, wherein a ratio of the mass of the first organic semiconductor compound to the mass of the second organic semiconductor compound is in a range of 0.5 to 2.0, and the ratio indicates the mass of the first organic semiconductor compound to the mass of the second organic semiconductor compound in the film forming composition.

## Patentansprüche

1. Organische Halbleiterfilm bildende Zusammensetzung, umfassend zumindest: eine erste organische Halbleiterverbindung, die in einem Molekül einen Mutterkern, der zwei oder mehr Thiophenringe aufweist und gebildet ist aus einer kondensierten Ringstruktur, die einschließlich der Thiophenringe mindestens vier oder mehr Ringe aufweist, und einen Substituenten X umfasst, der an den Mutterkern gebunden ist,;
eine zweite organische Halbleiterverbindung, die den gleichen Mutterkern wie den Mutterkern der ersten organischen Halbleiterverbindung umfasst und irgendein Erfordernis erfüllt, ausgewählt aus der Gruppe, bestehend aus den folgenden Erfordernissen 1 bis 3; und
ein organisches Lösungsmittel,
Erfordernis 1: die zweite organische Halbleiterverbindung umfasst einen Substituenten Y, der an den Mutterkern in der zweiten organischen Halbleiterverbindung gebunden ist und sich von dem Substituenten X in der ersten organischen Halbleiterverbindung unterscheidet,
Erfordernis 2: die zweite organische Halbleiterverbindung umfasst den Substituenten X, der an den Mutterkern gebunden ist, und eine Bindungsposition des Substituenten X in Bezug auf den Mutterkern in der ersten organischen Halbleiterverbindung unterscheidet sich von einer Bindungsposition des Substituenten X in Bezug auf den Mutterkern in der zweiten organischen Halbleiterverbindung, und
Erfordernis 3: die zweite organische Halbeiterverbindung weist keinen Substituenten auf,
worin der Mutterkern mindestens drei oder mehr Thiophenringe aufweist,
worin der Substituent X und der Substituent Y Substituenten sind, die jeweils eine Alkylgruppe mit 1 bis 16 Kohlenstoffatomen umfassen, und
**dadurch gekennzeichnet, dass** das Verhältnis der Masse der ersten organischen Halbleiterverbindung zur Masse der zweiten organischen Halbleiterverbindung im Bereich von 0,3 bis 3,0 liegt und
das Verhältnis die Masse der ersten organischen Halbleiterverbindung zur Masse der zweiten organischen Halbleiterverbindung in der filmbildenden Zusammensetzung bezeichnet.

2. Organische Halbleiterfilm bildende Zusammensetzung gemäß Anspruch 1, worin der Mutterkern drei oder vier Thiophenringe umfasst.

3. Organische Halbleiterfilm bildende Zusammensetzung gemäß Anspruch 1 oder 2, worin der Mutterkern drei Thiophenringe umfasst.

4. Organische Halbleiterfilm bildende Zusammensetzung gemäß irgendeinem der Ansprüche 1 bis 3, worin die Anzahl der Ringe in dem Mutterkern fünf ist.

5. Organische Halbleiterfilm bildende Zusammensetzung gemäß irgendeinem der Ansprüche 1 bis 4, worin die Alkylgruppe eine lineare Alkylgruppe ist.

6. Organische Halbleiterfilm bildende Zusammensetzung gemäß irgendeinem der Ansprüche 1 bis 5, worin die zweite organische Halbeiterverbindung das Erfordernis 1 oder das Erfordernis 2 erfüllt,
worin die erste organische Halbleiterverbindung zwei Substituenten X umfasst und die zweite organische Halbleiterverbindung zwei Substituenten Y umfasst, wenn das Erfordernis 1 erfüllt ist, und
die erste organische Halbleiterverbindung zwei Substituenten X umfasst und die zweite organische Halbleiterverbindung zwei Substituenten X umfasst, wenn das Erfordernis 2 erfüllt ist.

7. Organische Halbleiterfilm bildende Zusammensetzung gemäß irgendeinem der Ansprüche 1 bis 5, worin die zweite organische Halbeiterverbindung das Erfordernis 1 erfüllt, und die Bindungsposition des Substituenten X in Bezug auf den Mutterkern in der ersten organischen Halbleiterverbindung die gleiche ist wie die Bindungsposition des Substituenten Y in Bezug auf den Mutterkern in der zweiten organischen Halbleiterverbindung.

8. Organische Halbleiterfilm bildende Zusammensetzung gemäß irgendeinem der Ansprüche 1 bis 7, worin die zweite organische Halbeiterverbindung das Erfordernis 1 erfüllt, und der Unterschied in der Anzahl der Kohlenstoffatome zwischen dem Substituenten X und dem Substituenten Y 4 oder weniger beträgt.

9. Organische Halbleiterfilm bildende Zusammensetzung gemäß irgendeinem der Ansprüche 1 bis 8, worin die zweite organische Halbeiterverbindung das Erfordernis 1 erfüllt, und der Substituenten X und der Substituenten Y lineare Alkylgruppe mit jeweils 1 bis 16 Kohlenstoffatomen sind.

10. Organische Halbleiterfilm bildende Zusammensetzung gemäß irgendeinem der Ansprüche 1 bis 9, worin die Gesamtmenge der ersten organischen Halbleiterverbindung und der zweiten organischen Halbleiterverbindung im Bereich von 0,4 bis 10,0 Masse-% liegt, bezogen auf die Gesamtmasse der Zusammensetzung.

11. Organische Halbleiterfilm bildende Zusammensetzung gemäß irgendeinem der Ansprüche 1 bis 10, worin die Gesamtmenge der ersten organischen Halbleiterverbindung und der zweiten organischen Halbleiterverbindung im Bereich von 0,6 bis 8,0 Masse-% liegt, bezogen auf die Gesamtmasse der Zusammensetzung.

12. Organische Halbleiterfilm bildende Zusammensetzung gemäß irgendeinem der Ansprüche 1 bis 11, worin das Verhältnis der Masse der ersten organischen Halbleiterverbindung zur Masse der zweiten organischen Halbleiterverbindung im Bereich von 0,5 bis 2,0 liegt, und das Verhältnis die Masse der ersten organischen Halbleiterverbindung zur Masse der zweiten organischen Halbleiterverbindung in der filmbildenden Zusammensetzung bezeichnet.

## Revendications

1. Composition filmogène organique semi-conductrice comprenant au moins : un premier composé organique semi-conducteur qui inclut un noyau mère qui comporte deux cycles thiophène ou plus et est formé d'une structure cyclique fusionnée comportant au moins quatre cycles ou plus incluant les cycles thiophène, et un substituant X lié au noyau mère dans une molécule ;
un second composé organique semi-conducteur qui inclut le même noyau mère que le noyau mère du premier composé organique semi-conducteur et satisfait à une exigence quelconque choisie dans le groupe constitué des exigences 1 à 3 suivantes ; et
un solvant organique,
Exigence 1 : Le second composé organique semi-conducteur inclut un substituant Y qui est lié au noyau mère dans le second composé organique semi-conducteur et différent du substituant X dans le premier composé organique semi-conducteur,
Exigence 2 : Le second composé organique semi-conducteur inclut le substituant X lié au noyau mère, et une position de liaison du substituant X par rapport au noyau mère dans le premier composé organique semi-conducteur est différente d'une position de liaison du substituant X par rapport au noyau mère dans le second composé organique semi-conducteur, et
Exigence 3 : Le second composé organique semi-conducteur n'inclut pas de substituant,
dans laquelle le noyau mère inclut au moins trois cycles thiophène ou plus,
dans laquelle le substituant X et le substituant Y sont des substituants incluant chacun un groupe alkyle comportant de1 à 16 atomes de carbone, et
**caractérisée en ce qu'**un rapport de la masse du premier composé organique semi-conducteur à la masse du second composé organique semi-conducteur est dans une plage de 0,3 à 3,0, et
le rapport indique la masse du premier composé organique semi-conducteur à la masse du second composé organique semi-conducteur dans la composition filmogène.

2. Composition filmogène organique semi-conductrice selon la revendication 1, dans laquelle le noyau inclut trois ou quatre cycles thiophène.

3. Composition filmogène organique semi-conductrice selon la revendication 1 ou 2, dans laquelle le noyau mère inclut trois cycles thiophène.

4. Composition filmogène organique semi-conductrice selon l'une quelconque des revendications 1 à 3, dans laquelle le nombre de cycles dans le noyau mère est de cinq.

5. Composition filmogène organique semi-conductrice selon l'une quelconque des revendications 1 à 4, dans laquelle le groupe alkyle est un groupe alkyle linéaire.

6. Composition filmogène organique semi-conductrice selon l'une quelconque des revendications 1 à 5, dans laquelle le second composé organique semi-conducteur satisfait à l'exigence 1 ou à l'exigence 2,
le premier composé organique semi-conducteur inclut deux substituants X et le second composé organique semi-conducteur inclut deux substituants Y dans un cas où l'exigence 1 est satisfaite, et
le premier composé organique semi-conducteur inclut deux substituants X et le second composé organique semi-conducteur inclut deux substituants X dans un cas où l'exigence 2 est satisfaite.

7. Composition filmogène organique semi-conductrice selon l'une quelconque des revendications 1 à 5, dans laquelle le second composé organique semi-conducteur satisfait à l'exigence 1,
et la position de liaison du substituant X par rapport au noyau mère dans le premier composé organique semi-conducteur est la même qu'une position de liaison du substituant Y par rapport au noyau mère dans le second composé organique semi-conducteur.

8. Composition filmogène organique semi-conductrice selon l'une quelconque des revendications 1 à 7, dans laquelle le second composé organique semi-conducteur satisfait à l'exigence 1, et
une différence dans le nombre d'atomes de carbone entre le substituant X et le substituant Y est de 4 ou moins.

9. Composition filmogène organique semi-conductrice selon l'une quelconque des revendications 1 à 8, dans laquelle le second composé organique semi-conducteur satisfait à l'exigence 1, et le substituant X et le substituant Y sont des groupes alkyles linéaires comportant chacun de 1 à 16 atomes de carbone.

10. Composition filmogène organique semi-conductrice selon l'une quelconque des revendications 1 à 9, dans laquelle la quantité totale du premier composé organique semi-conducteur et du second composé organique semi-conducteur est dans une plage de 0,4 % à 10,0 % en masse par rapport à la masse totale de la composition.

11. Composition filmogène organique semi-conductrice selon l'une quelconque des revendications 1 à 10, dans laquelle la quantité totale du premier composé organique semi-conducteur et du second composé organique semi-conducteur est dans une plage de 0,6 % à 8,0 % en masse par rapport à la masse totale de la composition.

12. Composition filmogène organique semi-conductrice selon l'une quelconque des revendications 1 à 11, dans laquelle un rapport de la masse du premier composé organique semi-conducteur à la masse du second composé organique semi-conducteur est dans une plage de 0,5 à 2,0, et le rapport indique la masse du premier composé organique semi-conducteur à la masse du second composé organique semi-conducteur dans la composition filmogène.
